(19) Europäisches Patentamt
European Patent Office
Office européen des brevets

(11) **EP 2 991 231 A1**

(12) **EUROPEAN PATENT APPLICATION**

(43) Date of publication:
**02.03.2016 Bulletin 2016/09**

(51) Int Cl.:
**H03M 13/11** (2006.01)          **H03M 13/25** (2006.01)
**H04L 1/00** (2006.01)

(21) Application number: **14183086.9**

(22) Date of filing: **01.09.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel-Lucent Deutschland AG 70435 Stuttgart (DE)**

(72) Inventor: **Schmalen, Laurent 70435 Stuttgart (DE)**

(74) Representative: **2SPL Patentanwälte PartG mbB Postfach 15 17 23 80050 München (DE)**

(54) **Multilevel encoding and multistage decoding**

(57)    Embodiments relate to multilevel encoding and multistage decoding concepts for reducing memory requirements at decoder side. Embodiments are particularly suited for LDPC block and/or LDPC convolutional component codes. The ideas of embodiments are threefold: Firstly, the decoder memory utilization may be decreased by the use of a special bit mapping that reduces the memory consumption of the egress memories. Further, ingress memories, which need to store complex values, may be reduced. This may be achieved by an optimization of the codes such that the decoding delays are minimized and/or by using hybrid schemes, where spatially coupled or convolutional LDPC codes are combined with LDPC block codes yielding an overall minimized memory usage.

Fig. 7

EP 2 991 231 A1

**Description**

Embodiments of the present disclosure relate to communication systems and, more particularly, to communication systems employing multilevel codes and corresponding multistage decoding.

Background

This section introduces aspects that may be helpful in facilitating a better understanding of the inventions. Accordingly, the statements of this section are to be read in this light and are not to be understood as admissions about what is in the prior art or what is not in the prior art.

A Low-Density Parity-Check (LDPC) code is a linear error correcting code for transmitting a message over a noisy transmission channel. It may be constructed using a sparse bipartite graph whose vertices can be divided into two disjoint independent sets $U$ and $V$ such that every edge connects a vertex in $U$ to one in $V$. Examples of bipartite graphs used for LPDC codes are the so-called Tanner graph or graph prototypes (protographs). In coding theory, bipartite graphs may be used to construct longer codes from smaller ones. Both LPDC encoders and LPDC decoders may employ these graphs extensively.

A possible application of LDPC codes is in optical or wireless communication systems. As the LDPC codes used in optical communications are mainly high-rate LDPC codes with rates higher than 0.8 (overhead smaller than 25%), these LDPC codes are usually based on parity check matrices of size $C$ (rows) $\times$ $N$ (columns), with $C << N$.

In the last few years, the class of spatially coupled code ensembles has emerged and has shown to have appealing properties. LDPC convolutional codes, which are one particular instance of spatially coupled codes, have been around for more than a decade, but only recently it has been noticed that the belief propagation thresholds of certain (terminated) protograph-based LDPC convolutional codes approach the Maximum A-Posteriori (MAP) thresholds of the underlying ensemble. Analogous to LDPC block codes, LDPC convolutional codes may be defined by sparse parity-check matrices, which allow them to be decoded using iterative message-passing algorithms.

The fact that spatially coupled codes are universally capacity-achieving makes them immediately attractive for use in multilevel coding with multistage decoding, as in this case a capacity-achieving coding and modulation scheme can be implemented. However, the fact that the so-called windowed decoder, which is usually employed for spatially coupled codes due to its attractivity, introduces a decoding delay of $w$ frames, such that at time instant $t$ we can only recover the information frame of instant $t$-$w$, poses some difficulties in using such codes in the multilevel-coding scheme. These difficulties result in additional required memory usage at the receiver.

Hence, there is a desire to reduce the memory usage at the receiving side.

Summary

Some simplifications may be made in the following summary, which is intended to highlight and introduce some aspects of the various exemplary embodiments, but such simplifications are not intended to limit the scope of the inventions. Detailed descriptions of a preferred exemplary embodiment adequate to allow those of ordinary skill in the art to make and use the inventive concepts will follow in later sections.

According to a first aspect of the present disclosure, embodiments provide a multilevel encoding method. The method includes partitioning a block of source data bits into $V$ source data sub-blocks. The $V$ source data sub-blocks are encoded with a respective component code to obtain $V$ encoded bit streams. Bits of the V encoded bit streams form a $V$-ary binary address word $(\boldsymbol{b}_1, \boldsymbol{b}_2 ..., \boldsymbol{b}_V)$. Further, the method includes mapping the binary address word to a modulation symbol $X$ of an $M$-ary ($M = 2^V$) modulation scheme by using a predetermined mapping function. According to information theory, the mutual information $I(X; Y)$ between the modulation symbol $X$ and a transmission channel output $Y$ equals the mutual information $I(\boldsymbol{b}_1, \boldsymbol{b}_2 ..., \boldsymbol{b}_V; Y)$ between the binary address word $(\boldsymbol{b}_1, \boldsymbol{b}_2 ..., \boldsymbol{b}_V)$ and the transmission channel output $Y$. According to embodiments, the predetermined mapping function minimizes the expression $\sum_{i=1}^{V}(V-i)I(\boldsymbol{b}_i; Y|\boldsymbol{b}_1, ..., \boldsymbol{b}_{i-1})$ for a plurality of possible mapping functions. In the latter expression $I(\boldsymbol{b}_i; Y|\boldsymbol{b}_1, ..., \boldsymbol{b}_{i-1})$ denotes the mutual information of an equivalent transmission channel i for transmitting bit $\boldsymbol{b}_i$ of the binary address word, provided that the bits $\boldsymbol{b}_1, ... , \boldsymbol{b}_{i-1}$ are known.

In one or more embodiments, the method may further include transmitting the modulation symbol $X$ over a transmission channel, which may be an optical channel, such as a fiber, for example. For example, the modulation symbol $X$ may be used to modulate a carrier signal, such as an optical signal or an Radio Frequency (RF) signal.

In one embodiment, encoding the $V$ source data sub-blocks comprises encoding each source data sub-block with a respective LDPC convolutional code having a syndrome former memory $\mu \geq 1$.

In another embodiment, encoding the $V$ source data sub-blocks comprises encoding at least a first of the $V$

source data sub-blocks with at least a first LDPC block code to obtain at least a first of the *V* multilevel encoded bit streams, and encoding at least a second of the *V* source data sub-blocks with at least a second LDPC convolutional code to obtain at least a second of the *V* multilevel encoded bit streams. That is to say, some embodiments suggest multilevel encoding based on using both LDPC block and LDPC convolutional codes. For example, LDPC block codes may be used to encode binary digits of "lower" levels, while LDPC convolutional codes may be used to encode binary digits of "higher" levels.

In one or more embodiments, the method includes, prior to mapping the binary address word to the modulation symbol, determining $\sum_{i=1}^{V}(V-i)I(b_i;Y|b_1,\dots,b_{i-1})$ for the plurality of possible mapping functions, respectively. Then the minimum is determined among the respective determined expressions. The mapping function corresponding to the minimum expression is then chosen as the predetermined mapping function. In some embodiments, the expression $\sum_{i=1}^{V}(V-i)I(b_i;Y|b_1,\dots,b_{i-1})$ may be determined and minimized for all *M*! possible mapping functions, respectively. Therein, *M*! denotes the factorial, i.e., *M*! = 1·2···(*M*-1)·*M*.

While in some embodiments the determination of the predetermined mapping function may take place "offline", e.g., before performing the multilevel coding method, it may also be performed "online", e.g., during performing the multilevel coding method. The latter option may be interesting for rather small modulation symbol alphabets and/or especially for varying channel conditions.

In one embodiment, determining the minimum includes modelling the transmission channel as an Additive White Gaussian Noise (AWGN) channel. This may be particularly useful for optical transmission channels, which are often assumed to be AWGN channels. In case of wireless communications, for example, other channel models, such as the Rayleigh channel model, may be of relevance.

Embodiments of the multilevel encoding method may be performed by an apparatus or device which is configured to carry out one or more acts of the method. Hence, according to a further aspect, embodiments also provide a multilevel encoding apparatus. The encoding apparatus includes a partitioning processor configured to partition a block of source data bits into V source data sub-blocks. The coding apparatus further includes an encoding processor configured to encode the *V* source data sub-blocks with a respective component code to obtain *V* encoded bit streams, wherein bits of the *V* encoded bit streams form a *V*-ary binary address word ($b_1$, $b_2$ ..., $b_V$). The coding apparatus also includes a mapper configured to map, based on a predetermined mapping function, the binary address word to a modulation symbol *X* of an *M*-ary ($M = 2^V$) modulation scheme, wherein the mutual information *I*(*X*; *Y*) between the modulation symbol *X* and a transmission channel output *Y* equals the mutual information *I*($b_1$, $b_2$ ..., $b_V$; *Y*) between the binary address word ($b_1$, $b_2$ ..., $b_V$) and the transmission channel output *Y*. Thereby the predetermined mapping function or circuitry implementing said predetermined mapping function is configured to minimize the expression $\sum_{i=1}^{V}(V-i)I(b_i;Y|b_1,\dots,b_{i-1})$ for a plurality of possible mapping functions. Here, *I*($b_i$; *Y*|$b_1$, ..., $b_{i-1}$) denotes the mutual information of an equivalent transmission channel i for transmitting bit $b_i$ of the binary address word, provided that the bits $b_1$, ..., $b_{i-1}$ are known.

Some embodiments comprise digital circuitry installed within the multilevel encoding apparatus for performing the respective methods. Such a digital control circuitry, e.g., a Digital Signal Processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments of the method, when the computer program is executed on a computer or a programmable hardware device.

According to yet a further aspect of the present disclosure, embodiments also provide a multistage decoding method. The method includes using a first windowed decoder stage operating on a window of $w_1$ copies of a submatrix (e.g., a row-defining matrix) defining a first parity-check matrix of a first LDPC convolutional code to decode, in accordance with a first LDPC decoding rule based on the first parity-check matrix, one or more first data bits of a first bit stream encoded with the first LDPC convolutional code. The first bit stream is one of $V \geq 2$ encoded bit streams. The multistage decoding method further includes using the decoded one or more first data bits as input for at least a second windowed decoder stage operating on a window of $w_2$ copies of a submatrix defining a second parity-check matrix of a second LDPC convolutional code to decode, in accordance with a second LDPC decoding rule based on the second parity-check matrix, one or more second data bits of a second bit stream encoded with the second LDPC convolutional code. Also the second bit stream is one of the V encoded bit streams. In the multi-stage decoding method, selecting sizes $w_1$, ... , $w_V$ of the windows of the *V* windowed decoders includes minimizing the expression $\sum_{j=1}^{V}(V-j)w_j$, while maintaining a Quality of Service (QoS) above a predefined threshold.

In some embodiments, maintaining the QoS above the predefined threshold includes keeping a decoded signal error rate at a given Signal-to-Noise Ratio (SNR) below a predefined error rate threshold.

In some embodiments, minimizing the expression $\sum_{j=1}^{V}(V-j)w_j$ includes minimizing the expression

$\sum_{j=1}^{V-1}\left(O\sum_{i=1}^{j}w_i+R_i\sum_{i=j+1}^{V}w_i\right)$. Here, $O$ may denote a factor related to a bit-width of information to be stored in a decoder memory. $R_i$ may denote a coding rate of the $i$-th component LDPC convolutional code.

In one or more embodiments, the method may further include receiving a transmission channel output signal, estimating a modulation symbol of an $M$-ary modulation scheme based on the transmission channel output signal, mapping the estimated $M$-ary modulation symbol to a $V$-ary binary address word ($b_1$, $b_2$ ... , $b_V$), wherein $M = 2^V$; and inputting the $i$-th bit $b_i$ of the binary address word to the $i$-th decoder stage.

In one embodiment the transmission channel is an optical channel. However, other channels, such as wireless fading channels, are also conceivable.

In one or more embodiments, the first LDPC decoding rule and/or the second LDPC decoding rule are based on an iterative row-layered LDPC decoding rule.

In some embodiments, the first LDPC convolutional code and/or the second LDPC convolutional code use a syndrome former memory $\mu \geq 1$, respectively.

In some embodiments, the multistage decoding method may further include using at least a further decoder stage to decode, in accordance with an LDPC block decoding rule based on a parity-check matrix, one or more first data bits of a further bit stream encoded with an LDPC block code. The LDPC block code may be used for bit streams of lower levels compared to the first and second LDPC convolutional codes, or vice versa.

Embodiments of the multistage decoding method may be performed by an apparatus which is configured to carry out one or more acts of the method. Hence, according to a further aspect of the present disclosure, embodiments also provide a multistage decoding apparatus. The decoding apparatus comprises a first windowed decoder stage configured to operate on a window of $w_1$ copies of a submatrix defining a first parity-check matrix of a first LDPC convolutional code to decode, in accordance with a first LDPC decoding rule based on the first parity-check matrix, one or more first data bits of a first bit stream encoded with the first LDPC convolutional code. The first bit stream is one of $V \geq 2$ multilevel encoded bit streams. The apparatus further includes at least a second windowed decoder stage configured to operate on a window of $w_2$ copies of a submatrix defining a second parity-check matrix of a second LDPC convolutional code to decode, in accordance with a second LDPC decoding rule based on the second parity-check matrix and based on the decoded one or more first data bits, one or more second data bits of a second bit stream encoded with the second LDPC convolutional code. The second bit stream is also one of the $V$ multilevel encoded bit streams. Sizes $w_1, ... , w_V$ of the windows of the $V$ windowed decoder stages are adapted to minimize the expression $\sum_{j=1}^{V}(V-j)w_j$ while maintaining a quality of service above a predefined threshold.

Some embodiments comprise digital circuitry installed within the multistage decoding apparatus for performing the respective method. Such a digital control circuitry, e.g., a DSP, an FPGA, an ASIC, or a general purpose processor, needs to be programmed accordingly. Hence, yet further embodiments also provide a computer program having a program code for performing embodiments of the multistage decoding method, when the computer program is executed on a computer or a programmable hardware device.

According to yet a further aspect of the present disclosure, embodiments also provide another multistage decoding method. The decoding method includes using at least a first decoder stage to decode, in accordance with at least a first LDPC decoding rule based on a first parity-check matrix, one or more first data bits of a first bit stream encoded with an LDPC block code. The first bit stream is one of $V \geq 2$ multilevel encoded bit streams. The method further includes using the decoded one or more first data bits as input for at least a second decoder stage operating on a window of $w_2$ copies of a submatrix defining a second parity-check matrix of an LDPC convolutional code to decode, in accordance with a second LDPC decoding rule based on the second parity-check matrix, one or more second data bits of a second bit stream encoded with the LDPC convolutional code. Also the second bit stream is one of the V multilevel encoded bit streams.

In one or more embodiments, the method includes selecting the size of the window of the at least second decoder stage to minimize the expression $\sum_{j=1}^{T}(V-j)w_j$, where $T$ denotes a number of decoder stages operating as windowed LDPC convolutional decoders, while maintaining a quality of service above a predefined threshold. In one embodiment, maintaining the quality of service above the predefined threshold includes keeping a decoded signal error rate at a given Signal-to-Noise Ratio below a predefined error rate threshold.

In one or more embodiments, the method may further include receiving a transmission channel output signal, estimating a modulation symbol of an $M$-ary modulation scheme based on the transmission channel output signal, mapping the estimated $M$-ary modulation symbol to a $V$-ary binary address word ($b_1$, $b_2$ ..., $b_V$), wherein $M = 2^V$, and

inputting the $i$-th bit $b_i$ of the binary address word to the $i$-th decoder stage.

In one or more embodiments, the transmission channel may be an optical channel, such as an optical fiber, for example.

In one or more embodiments, the first LDPC decoding rule and/or the second LDPC decoding rule are based on an iterative row-layered decoding rule. The at least one LDPC convolutional code may use a syndrome former memory $\mu \geq 1$.

Embodiments of the multistage decoding method may be performed by an apparatus which is configured to carry out one or more acts of the method. Hence, according to a further aspect, embodiments also provide a multistage decoding apparatus. The decoding apparatus comprises at least a first decoder stage configured to decode, in accordance with at least a first LDPC decoding rule based on a first parity-check matrix, one or more first data bits of a first bit stream encoded with an LDPC block code. The first bit stream is one of $V \geq 2$ multilevel encoded bit streams. The apparatus further comprises at least a second windowed decoder stage configured to operate on a window of $w_2$ copies of a submatrix defining a second parity-check matrix of an LDPC convolutional code to decode, in accordance with a second LDPC decoding rule based on the second parity-check matrix and based on the decoded one or more first data bits, one or more second data bits of a second bit stream encoded with the LDPC convolutional code. Also the second bit stream is one of the $V$ multilevel encoded bit streams.

According to yet a further aspect, embodiments also provide a corresponding multilevel coding method. The method includes partitioning a block of source data bits into $V$ source data sub-blocks, encoding at least a first of the $V$ source data sub-blocks with at least a first LDPC block code to obtain at least a first of $V$ encoded bit streams, and encoding at least a second of the $V$ source data sub-blocks with at least a second LDPC convolutional code to obtain at least a second of the $V$ encoded bit streams. Bits of the $V$ encoded bit streams form a $V$-ary binary address word $(b_1, b_2 ..., b_V)$ which is mapped, using a predetermined mapping function, to a modulation symbol $X$ of an $M$-ary modulation scheme, with $M = 2^V$.

The mutual information $I(X; Y)$ between the modulation symbol $X$ and a transmission channel output $Y$ equals the mutual information $I(b_1, b_2 ..., b_V; Y)$ between the binary address word $(b_1, b_2 ..., b_V)$ and the transmission channel output $Y$. In some embodiments, the predetermined mapping function may minimize the expression $\sum_{i=1}^{V}(V-i)I(b_i ; Y|b_1, ..., b_{i-1})$ for a plurality of possible mapping functions, with $I(b_i; Y|b_1, ..., b_{i-1})$ denoting the mutual information of an equivalent or virtual transmission channel $i$ for transmitting bit $b_i$ of the binary address word, provided that the bits $b_1, ..., b_{i-1}$ are known.

In one or more embodiments, the method further includes transmitting the modulation symbol $X$ over a transmission channel, which may be an optical channel.

In one or more embodiments, the method further includes, prior to mapping the binary address word to the modulation symbol, determining the expression $\sum_{i=1}^{V}(V-i)I(b_i ; Y|b_1, ..., b_{i-1})$ for the plurality of possible mapping functions, respectively; determining the minimum among the respective determined expressions; and choosing the mapping function corresponding to the minimum expression as the predetermined mapping function. In one embodiment, the expression $\sum_{i=1}^{V}(V-i)I(b_i ; Y|b_1, ..., b_{i-1})$ may be determined for all $M!$ possible mapping functions, respectively. Thereby, determining the minimum may comprise modelling the transmission channel as an AWGN channel, for example.

Embodiments of the multilevel coding method may be performed by an apparatus which is configured to carry out one or more acts of the method. Hence, according to a further aspect, embodiments also provide a multilevel encoding apparatus. The encoding apparatus comprises a partitioning processor configured to partition a block of source data bits into $V$ source data sub-blocks. The apparatus also includes an encoder configured to encode at least a first of the $V$ source data sub-blocks with at least a first LDPC block code to obtain at least a first of $V$ encoded bit streams, and to encode at least a second of the $V$ source data sub-blocks with at least a second LDPC convolutional code to obtain at least a second of the $V$ encoded bit streams. Bits of the $V$ encoded bit streams form a $V$-ary binary address word $(b_1, b_2 ... , b_V)$. The coding apparatus also includes a mapper configured to map, based on a predetermined mapping function, the binary address word to a modulation symbol $X$ of an $M$-ary modulation scheme.

Some embodiments comprise digital circuitry installed within the multilevel coding apparatus for performing the respective method. Such a digital control circuitry, e.g., a DSP, an FPGA, an ASIC, or a general purpose processor, needs to be programmed accordingly. Hence, yet further embodiments also provide a computer program having a program code for performing embodiments of the multistage decoding method, when the computer program is executed on a computer or a programmable hardware device.

The person skilled in the art of channel coding will appreciate that the different aforementioned aspects of the persent disclosure may be combined in various ways to obtain various benefits. For example, all aspects allow for a combination of LDPC block and LDPC convoltional codes as component codes of multilevel coding and/or corresponding multistage decoding schemes.

A benefit of embodiments is the use of capacity achieving codes and a capacity achieving coded modulation scheme with reduced decoder memory requirements, which will be further detailed in the sequel.

Brief description of the Figures

Some embodiments of apparatuses and/or methods will be described in the following by way of example only, and with reference to the accompanying figures, in which

Fig. 1 illustrates block diagram of a conventional row-layered LDPC decoding algorithm;

Fig. 2a illustrates a system model with a spatially coupled encoder;

Fig. 2b shows four phases of windowed decoding of spatially coupled LDPC convolutional codes;

Fig. 3 illustrates an example of a copy-and-permute operation for a protograph-based LDPC code using a protomatrix **B**;

Fig. 4 shows a visualization of a parity check matrix **H** obtained by lifting of the lifting matrix **A** obtained from the protograph shown in Fig. 3;

Fig. 5 shows a proto graph-based code design for spatially-coupled Codes and its corresponding protograph matrix **B**;

Fig. 6 illustrates a mapping function $X = \varphi(b_1, b_2, b_3)$ for an 8-APSK constellation;

Fig. 7 shows a transmitter and receiver of multilevel coding with multi-stage decoding;

Fig. 8 shows a decoding pipeline of a multi-stage decoder;

Fig. 9 shows a block diagram of an example receiver for multilevel coding with multi-stage decoding and windowed decoding of spatially coupled codes;

Fig. 10 shows a flowchart of a multilevel coding method according to a first aspect;

Fig. 11 shows an optimized bit mapping for the 8-APSK constellation of Fig. 6 minimizing the amount of required memory for a system setup depicted in Fig. 7;

Fig. 12 shows a flowchart of a multistage decoding method according to a second aspect;

Fig. 13 illustrates a receiver of multilevel coding with multistage decoding and windowed decoding of spatially coupled codes where each decoder has a different, optimized window length;

Fig. 14 illustrates a required $E_b/N_0$ for different window configurations for the 8-QAM example with the constellation of Fig. 6;

Fig. 15 shows a flowchart of a hybrid multistage decoding method according to a further aspect;

Fig. 16 illustrates a decoder of a modified hybrid encoder where the last code is a spatially coupled code;

Fig. 17 shows a decoder of a modified hybrid encoder where only the $T=2$ last two codes ($V-1$ and $V$) are spatially coupled codes;

Fig. 18 illustrates a multilevel hybrid encoder where only the last $T$ codes are spatially coupled codes; and

Fig. 19 shows a flowchart of a hybrid multilevel encoding method according to a further aspect:

Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

For a better understanding of embodiments, a short introduction to LDPC codes and some related decoding algorithms will be provided in the following.

An LDPC code may be defined by a sparse parity-check matrix $\mathbf{H}$ of dimension $C \times N$, where $N$ is the LDPC code word length (e.g., in bits) of the LDPC code and C denotes the number of parity bits or symbols. The rows of a parity check matrix are parity checks on the code words of a code. That is, they show how linear combinations of certain digits of each code word equal zero. Usually, the number of information symbols equals $N\text{-}C$ (but can be larger, depending on the rank of the parity-check matrix $\mathbf{H}$). The design rate of the code amounts to $r = (N\text{-}C)/N$. The overhead of the code is defined as $OH = 1/r - 1 = C/(N\text{-}C)$. Sparse means that the number of 1s in $\mathbf{H}$ is small compared to the number of zero entries. Practical LDPC codes usually have a fraction of "1s" that is below 1% by several orders of magnitude.

We start by introducing some notation and terminology related to LDPC codes. Each column of the parity check matrix $\mathbf{H}$ corresponds to one symbol (e.g., a bit) of a Forward Error Correction (FEC) frame or LPDC code word. As LDPC codes can also be represented in a graphical structure called Tanner graph, the columns of H and thus the FEC frame (LPDC code word) symbols are sometimes also referred to as variable nodes, referring to the graph-theoretic representation. Similarly, each row of $\mathbf{H}$ corresponds to a parity check equation and ideally defines a parity symbol (e.g., a parity bit), if $\mathbf{H}$ has full rank. For example, the rank can be defined as the column rank. The column rank of a matrix $\mathbf{H}$ is the maximum number of linearly independent column vectors of $\mathbf{H}$. Correspondingly, the row rank of $\mathbf{H}$ is the maximum number of linearly independent row vectors of $\mathbf{H}$. Owing to the Tanner graph representation, the rows of $\mathbf{H}$ are associated to so-called check nodes, and the columns of $\mathbf{H}$ are associated to so-called variable nodes. Further, the $C$ rows of $\mathbf{H}$ specify $C$ check node connections, and the $N$ columns of $\mathbf{H}$ specify $N$ variable node connections. Thereby, check node $i$ is connected to variable node $j$ whenever element $h_{i,j}$ in $\mathbf{H}$ is different from zero. Note that the row rank and the column rank of a matrix $\mathbf{H}$ are always equal, which is a well-known result in linear algebra.

In order to describe an exemplary LDPC decoder we introduce some additional notation. First, we denote by $\mathbf{u}$ a vector of $K = N - C$ information symbols. The single elements of $\mathbf{u}$ are denoted by $u_i$, i.e., $\mathbf{u} = (u_1, u_2, ..., u_i, ..., u_K)^T$. After encoding with an exemplary LDPC encoder, an LDPC code word $\mathbf{x} = (x_1, x_2, ..., x_N)^T$ of length $N$ results. We denote by $x_i$ the single elements of the code word $\mathbf{x}$. The LDPC code is said to be systematic if the information vector $\mathbf{u}$ is included in the code word, e.g., if (after possible rearrangement) $\mathbf{x} = (u_1,..., u_K, p_1, ... p_c)^T$, with $\mathbf{p} = (p_1, ..., p_c)^T$ denoting the vector of $C$ parity symbols. Furthermore, let the set $N(m)$ denote the positions of the 1s in the $m$-th row of $\mathbf{H}$, i.e., $N(m) = \{i: H_{m,i} = 1\}$. A binary vector $\mathbf{x}$ is a code word of the LDPC code defined by $\mathbf{H}$, if $\mathbf{Hx} = 0$, with the additions defined over the binary field (addition modulo-2, or XOR, respectively), for example. The set of code words is thus defined to be the null space of **H**. This signifies that the product of each row of **H** and **x** is zero, or $\sum_{j\in\mathcal{N}(m)} x_j = 0,$ for all $m$ with $1 \le m \le M$.

Let us illustrate the concept of LDPC codes by a "toy" example. This example defines a binary parity check matrix **H** of two concatenated (4, 5) single parity check codes, separated by a 4x5 block-interleaver. The exemplary parity check matrix H of dimension 9x25 is given by

$$
\mathbf{H} = \begin{pmatrix}
1 & 1 & 1 & 1 & & & & & & & & & & & & & 1 & & & & & & & & \\
& & & & 1 & 1 & 1 & 1 & & & & & & & & & & 1 & & & & & & & \\
& & & & & & & & 1 & 1 & 1 & 1 & & & & & & & 1 & & & & & & \\
& & & & & & & & & & & & 1 & 1 & 1 & 1 & & & & 1 & & & & & \\
1 & & & & & 1 & & & & 1 & & & & 1 & & & & & & & 1 & & & & \\
& 1 & & & & & 1 & & & & 1 & & & & 1 & & & & & & & 1 & & & \\
& & 1 & & & & & 1 & & & & 1 & & & & 1 & & & & & & & 1 & & \\
& & & 1 & & & & & 1 & & & & 1 & & & & 1 & & & & & & & 1 & \\
& & & & & & & & & & & & & & & & 1 & 1 & 1 & 1 & & & & & 1
\end{pmatrix}.
$$

Note that for simplicity reasons only the 1s are illustrated in the parity check matrix **H** above. Thus, $C = 9$, $N = 25$, and the code has an overhead of 56% (given by $C/(N - C)$) or a rate of $r = 0.64$, equivalently. We have $N(1) = \{1; 2; 3; 4; 17\}$, $N(2) = \{5; 6; 7; 8; 18\}$, $N(3) = \{9; 10; 11; 12; 19\}$, $N(4) = \{13; 14; 15; 16; 20\}$, $N(5) = \{1; 5; 9; 13; 21\}$, $N(6) = \{2; 6; 10; 14; 22\}$, $N(7) = \{3; 7; 11; 15; 23\}$, $N(8) = \{4; 8; 12; 16; 24\}$, $N(9) = \{17; 18; 19; 20; 25\}$. This means for instance that we have (using the first row of **H**) $x_1+x_2+x_3+x_4+x_{17}=0$, or, if the code is systematic, $u_1+u_2+u_3+u_4+p_1=0$, i.e., $p_1=u_1+u_2+u_3+u_4$, defines the first parity bit.

One common decoding algorithm for LDPC codes is the so-called "sum-product" decoding algorithm and its simplified versions. These algorithms can be described either in a graph structure commonly denoted Tanner graph, or given directly in a form suitable for implementation. While the former is advantageous for describing and understanding the underlying operations, we focus on the latter.

In the context of coherent detection, e.g., in optical communications, we can usually assume an equivalent Additive White Gaussian Noise (AWGN) channel model for the transmission channel. This assumption is justified by the central limit theorem which applies due to the extensive use of filtering in inner Digital Signal Processing (DSP) stages of a transmitter and/or receiver. If we denote by $x_i$ ($i = 1, ..., N$) the single bits of an LDPC code word **x** as defined above, then the received values at the input of an LDPC decoder amount to $y_i = x_i + n_i$, with $n_i$ ($i = 1, ..., N$) being Gaussian distributed noise samples of zero mean and variance $\sigma^2$. Usually, the received noisy samples are converted into the Log-Likelihood Ratio (LLR) domain, which leads to a numerically more stable decoder implementation. The LLR of a received sample $y_i$ may be defined as

$$
L(y_i) = \log\left(\frac{p(y_i \mid x_i = 0)}{p(y_i \mid x_i = 1)}\right) \tag{1}
$$

with $p(y_i \mid x_i = k) = \exp\left(-(y_i - (1-2k))^2 / (2\sigma^2)\right) / \sqrt{2\pi\sigma^2}$ denoting the probability density function (pdf) of the received sample $y_i$ under AWGN assumption conditioned on the transmitted bit $x_i$ and with bipolar signaling ($x_i=0 \rightarrow +1$, $x_i=1 \rightarrow -1$). Conveniently, it turns out that $L(y_i) = y_i \cdot 2/\sigma^2 = y_i \cdot L_c$ under the AWGN assumption. Usually, the value $L_c = 2/\sigma^2$ is assumed to be constant and predetermined.

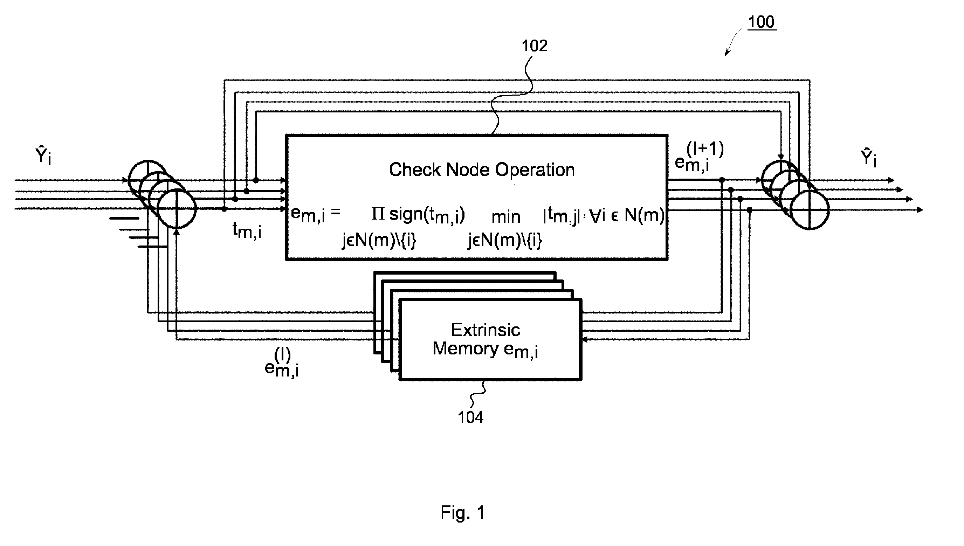

Turning now to Fig. 1, we describe a conventional row-layered LDPC decoding algorithm. Here, an LDPC decoder 100 continuously updates the received LLR values with the goal to compute LLRs that approximate the Maximum A-Posteriori (MAP) values. The received vector of LLRs **y** is therefore copied to a memory $\hat{\mathbf{y}}$ of size $N$, which is continuously updated. This memory maybe referred to as LLR memory or a-posteriori memory in later sections of this specification. The decoding operation in the row-layered decoder 100 comprises three acts, where a) the first act prepares the input data, b) the second act performs the computation of new extrinsic data and c) the final act updates the LLR memory. The row-layered LDPC decoder 100 may carry out the three steps sequentially for each row of the parity check matrix **H.** After all rows have been considered, a single decoding iteration has been carried out. The LDPC decoder 100 usually carries out several iterations, where the number depends on the available resources.

In the following, we describe the aforementioned three acts for a single row $m$ of H. The first step a) comprises computing card ($N(m)$) = $d_c$ (card = cardinality) temporary values $t_{m,i}$, with

$$t_{m,i} = \hat{y}_i - e_{m,i}^{(l)} \qquad \text{for all } i \in \mathcal{N}(m) \tag{2}$$

for all non-zero entries (indexed by $i$) of the $m$'th row of **H**. The superscript[(l)] denotes the iteration counter, i.e., the operations are carried out in the $l$-th iteration of the row-layered LDPC decoding procedure. The value $e_{m,i}$ is the (stored) extrinsic memory for row $m$ and variable $\hat{y}_i$. At the beginning of the decoding of a single LDPC frame (code word), all $e_{m,i}$ may be initialized by zero (i.e., $e_{m,i}^{(1)} = 0$) and then continuously updated. Note that in total only $\Sigma_m$ card ($N(m)$) memory locations may be used for storing the $e_{m,i}$. If the code is check-regular, $\Sigma_m$ card ($N(m)$) = $C \cdot d_c$, where $d_c$ is the (constant) number of "1"s in each row of the parity-check matrix **H** In the second step, the extrinsic memory 104 for the subsequent iteration ($l$+1) may be updated using the $t_{m,i}$ according to

$$e_{m,i}^{(l+1)} = 2 \cdot \tanh^{-1}\left(\prod_{j \in \mathcal{N}(m)\backslash\{i\}} \tanh\left(\frac{t_{m,j}}{2}\right)\right) \qquad \text{for all } i \in \mathcal{N}(m)$$

$$= \left[\prod_{j \in \mathcal{N}(m)\backslash\{i\}} \text{sign}\left(t_{m,j}\right)\right] \cdot \phi\left(\sum_{j \in \mathcal{N}(m)\backslash\{i\}} \phi\left(|t_{m,j}|\right)\right), \quad \text{with} \quad \phi(\tau) = -\log\left(\tanh\left(\frac{\tau}{2}\right)\right) = \log\left(\frac{e^\tau + 1}{e^\tau - 1}\right) \tag{3}$$

where the log-domain expression of the Sum-Product Algorithm (SPA) according to the second line of equation (3) may be more suitable for practical implementations, as the multiplication is replaced by an addition and instead of two functions $\tanh(\cdot)/\tanh^{-1}(\cdot)$, only a single function $\phi(\cdot)$ needs to be implemented (or approximated by a look-up table). The product (or the sum) of equation (3) may be carried out over all entries in $N(m)$ except the one under consideration $i$. This is indicated by the notation $N(m)\backslash\{i\}$. For instance, in the above example, where $N(5)$ = {1; 5; 9; 13; 21}, $e_{5,13}^{(l+1)}$ may be computed corresponding to

$$e_{5,13}^{(l+1)} = 2 \cdot \tanh^{-1}\left(\prod_{j \in \mathcal{N}(5)\backslash\{13\}} \tanh\left(\frac{t_{m,j}}{2}\right)\right) = 2 \cdot \tanh^{-1}\left(\prod_{j \in \{1;5;9;21\}} \tanh\left(\frac{t_{m,j}}{2}\right)\right)$$

$$= 2 \cdot \tanh^{-1}\left(\tanh\left(\frac{t_{5,1}}{2}\right)\tanh\left(\frac{t_{5,5}}{2}\right)\tanh\left(\frac{t_{5,9}}{2}\right)\tanh\left(\frac{t_{5,21}}{2}\right)\right). \tag{4}$$

The derivation of equation (4) for the extrinsic update is beyond the scope of this specification. Usually, if high LDPC decoder throughputs shall be achieved, the computation of $e_{m,i}$ can be further simplified. An often employed simplification of the SPA log-domain equation (3), which we will consider in the following, is the so-called min-sum approximation or min-sum algorithm which leads to

$$e_{m,i}^{(l+1)} = \left[\prod_{j \in \mathcal{N}(m)\backslash\{i\}} \text{sign}(t_{k,j})\right] \min_{j \in \mathcal{N}(m)\backslash\{i\}} |t_{m,j}| \qquad \text{for all } i \in \mathcal{N}(m). \tag{5}$$

As the second act b) computes the output of the parity check node $m$ of the check node in the graphical representation of LDPC codes, it is frequently denoted by check node operation 102. Hence, equation (5) may be denoted as min-sum check-node update operation having reduced complexity vis-à-vis the SPA check-node update operations of equation (3).

In the next decoding act c), the LLR memory may be updated corresponding to

$$\hat{y}_i = t_{m,i} + e_{m,i}^{(l+1)} \qquad \text{for all } i \in \mathcal{N}(m) \qquad (6)$$

and the LDPC decoder 100 may continue with decoding row $m+1$ or, if $m = C$, restarts at $m = 1$ (next iteration, $l + 1$).

Fig. 1 shows the simplified block diagram 100 of the min-sum check-node update operation for computing $e_{m,i}^{(l+1)}$ according to equation (5) for card ($N$ ($m$)) = 4 (i.e., H contains for 1s at row $m$). As has been explained before, the check node operation 102 may be realized by equations (3) (log-domain SPA) or (5) (min-sum domain). Note that a routing network to access the different $\hat{y}_i$ (which are not necessarily stored in neighboring memory locations) is not shown in the Fig. 1.

The second step b), i.e., the check-node update, can be further simplified in actual implementations. Let $\mu_m^{[1]} = \min\limits_{j \in \mathcal{N}(m)} |t_{m,j}|$ be the first minimum of the absolute value of all involved incoming messages $t_{m,j}$ at row $m$ and let $i_m^{[1]} = \arg \min\limits_{j \in \mathcal{N}(m)} |t_{m,j}|$ be the position (i.e., the index) of this first minimum. Let furthermore $\mu_m^{[2]} = \min\limits_{j \in \mathcal{N}(m) \setminus \{i_m^{[1]}\}} |t_{m,j}|$ be the second minimum (larger than the first minimum) of all incoming messages at row $m$. We further define $s_m = \prod\limits_{j \in \mathcal{N}(m)} \text{sign}(t_{m,j})$. The output message can then be computed corresponding to

$$e_{m,i}^{(l+1)} = s_m \cdot \text{sign}(t_{m,i}) \cdot \begin{cases} \mu_m^{[1]} & \text{if } i \neq i_m^{[1]} \\ \mu_m^{[2]} & \text{if } i = i_m^{[1]} \end{cases} . \qquad (7)$$

Note that equation (7) is an alternative representation of the min-sum check-node update operation of equation (5). Thus, one burden for implementing the check node operation 102 for computing $e_{m,i}^{(l+1)}$ consists in finding the first and second minimum of the incoming messages together with the position of the first minimum. The memory requirements of this algorithm are $N$ memory cells for storing the (continuously updated) a-posteriori values $\hat{z}_i$. Additionally, the storing requirements of the extrinsic memory $e_{m,i}$ 104 amount to the total number of 1s in the parity check matrix **H**, however, due to the simplified implementation using the minimum approximation, the extrinsic memory 104 does not need to store all $d_c$ different values per row, but only the $d_c$ different signs, both minima $\mu_m^{[1]}$ and $\mu_m^{[2]}$, and the location index of the first minimum $i_m^{[1]}$. The values $e_{m,i}$ can then be computed on the fly as required.

As the min-sum algorithm according to equation (5) is only an approximation to the full belief-propagation expression of equation (3), numerous attempts have been made to improve the performance of the min-sum algorithm, i.e., the min-sum check-node update operation. One notable improvement is the so-called offset min-sum algorithm. The check-node update rule of the offset min-sum algorithm reads

$$e_{m,i}^{(l+1)} = s_m \cdot \text{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases}, \qquad (8)$$

where the offset correction variable β can either be constant and determined offline or be updated during decoding according to a predefined rule.

While in the 1960s and the following decades, most coding research focused on block coding techniques, many practical coding schemes were based upon convolutional codes. With the advent of turbo codes and the rediscovery of LDPC codes, this suddenly changed such that nowadays most new coding schemes are again block codes. The trend is, however, to return back to convolutional-like structures.

In the last few years, the class of spatially coupled code ensembles has emerged and has shown to have appealing properties. LDPC convolutional codes, which are one particular instance of spatially coupled codes, have been around for more than a decade, but only recently it has been noticed that the belief propagation thresholds of certain (terminated) protograph-based LDPC convolutional codes approach the MAP thresholds of the underlying ensemble. Thus, contrary to a common belief, introducing structure into LDPC codes leads to a class of (degenerated) realizations of LDPC codes which show superior performance under belief propagation decoding. This effect of threshold saturation by introducing structure has been analyzed for the Binary Erasure Channel (BEC) and it has been shown that spatially coupled LDPC codes can asymptotically achieve the MAP threshold of the underlying regular ensemble under belief propagation decoding. Recently, this result has been extended to more general channels and it has been shown that spatially coupled ensembles universally achieve capacity over binary-input memoryless symmetric-output channels: most codes of this ensemble are good for each channel realization of this class of channels.

For simplicity, we exemplarily consider time-independent LDPC convolutional codes, but all embodiments can be extended to time-varying LDPC convolutional codes by introducing additional time indexing. Instead of being a block code of dimension $N$ with parity-check matrix $\mathbf{H}$, a time-independent LDPC convolutional code has an infinitely extended parity-check matrix $\mathbf{H}_{conv}$, which has the following form

$$\mathbf{H}_{conv} = \begin{pmatrix} \ddots & & & & & & \\ \ddots & \mathbf{H}_0 & & & & & \\ \vdots & \mathbf{H}_1 & \mathbf{H}_0 & & & & \\ \ddots & \vdots & \mathbf{H}_1 & \mathbf{H}_0 & & & \\ \mathbf{H}_\mu & \vdots & & \mathbf{H}_1 & \ddots & & \\ & \mathbf{H}_\mu & & \vdots & \ddots & \\ & & \mathbf{H}_\mu & & \vdots & \\ & & & & \ddots & \end{pmatrix}_\infty .$$

Thereby the value $\mu$ is commonly called the syndrome former memory, in analogy to convolutional codes. For simplicity only, we look in the remainder of this specification at the case $\mu = 1$, leading to

$$\mathbf{H}_{conv} = \begin{pmatrix} \ddots & & & & \\ \ddots & \mathbf{H}_0 & & & \\ & \mathbf{H}_1 & \mathbf{H}_0 & & \\ & & \mathbf{H}_1 & \mathbf{H}_0 & \\ & & & \mathbf{H}_1 & \ddots \\ & & & & \ddots \end{pmatrix}_\infty .$$

Note, however, that embodiments also comprise implementations with values of $\mu$ other than 1, e.g., $\mu = 0$ (leading to an LDPC block code) or $\mu > 1$. We see that $\dim(\mathbf{H}_0) = \dim(\mathbf{H}_1) = C \times N$ has to hold. Note that in practical systems, the code is usually terminated. For optical communication systems, which may usually be implemented in a stream-like mode, it is convenient to terminate the code only at the beginning of a transmission (or at the beginning of a super-frame) and thus we may consider left-terminated codes with the parity-check matrix

$$\mathbf{H}_{conv} = \begin{pmatrix} \mathbf{H}_0 & & & & \\ \mathbf{H}_1 & \mathbf{H}_0 & & & \\ & \mathbf{H}_1 & \ddots & & \\ & & \ddots & \mathbf{H}_0 & \\ & & & \mathbf{H}_1 & \mathbf{H}_0 \\ & & & & \mathbf{H}_1 & \ddots \\ & & & & & \ddots \end{pmatrix}_\infty$$

This termination has a crucial effect on the performance and is responsible for the outstanding asymptotic performance of this class of codes.

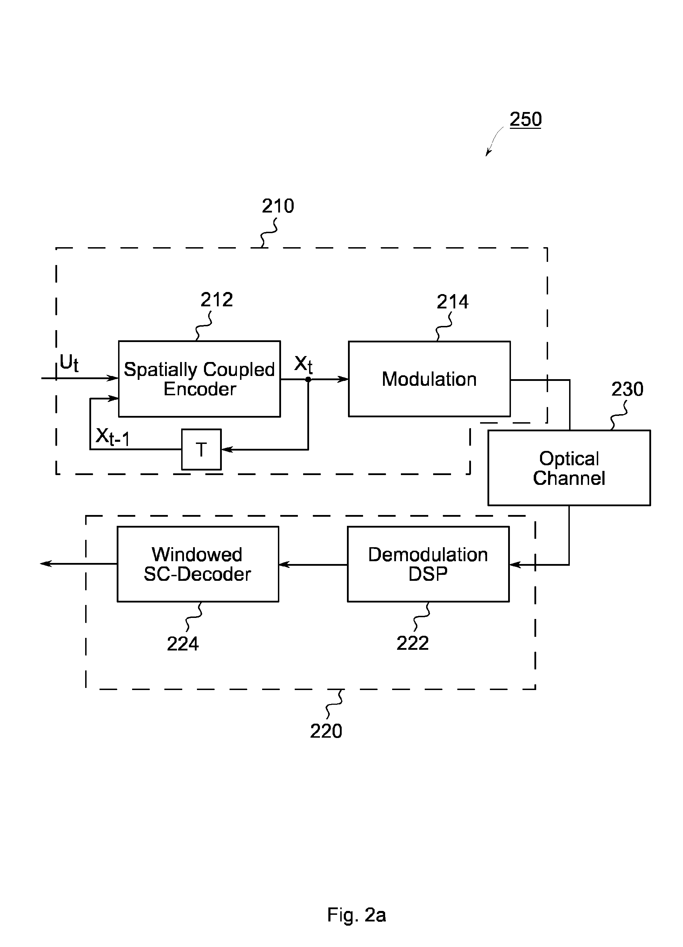

In the remainder of the description we consider the case $\mu = 1$. Embodiments can however be extended to larger values of $\mu$ in a straight forward fashion. An example encoder 212 for the LDPC convolutional code with $\mu = 1$ and parity check matrix $\mathbf{H}_{conv}$ is illustrated in the system model 250 of **Fig. 2a**. The system model 250 comprises an optical transmitter 210 and receiver 220 connected via an optical channel 230, such as a fiber, for example. The optical communication channel 230 may also comprise additional inner digital signal processing stages, such as equalization, dispersion compensation, MIMO processing, phase offset estimation and correction, frequency offset estimation and correction, etc. The skilled person having benefit from the present disclosure will also appreciate that embodiments are not restricted to optical communication systems, but may also employed in other wired or wireless communication systems.

The LDPC convolutional encoder 212 encodes a block of information bits $\mathbf{u}_t$ (note that we include time indices to stress the dependence on previous frames) using $\mathbf{H}_0$ and $\mathbf{H}_1$ together with a previously encoded block $\mathbf{x}_{t-1}$ yielding $\mathbf{x}_t$. The size of each $\mathbf{x}_t$ amounts $N$, with dim($\mathbf{H}_0$)=dim($\mathbf{H}_1$) = $C \times N$. As $\mathbf{H}_0$ usually has a simple structure with a single identity matrix on the right hand part, encoding is rather trivial: each parity bit (with the position of the parity bit corresponding to the positions of the identity matrix) is directly given from the information bits $\mathbf{u}_t$ and the bits of the previously encoded block $\mathbf{x}_{t-1}$. We may define $\mathbf{H}_0 = [\mathbf{H}_{0,s}\ \mathbf{I}]$ with $\mathbf{I}$ denoting the identity matrix and we define the sets

$$\mathcal{N}_1(m) = \{i : \mathrm{H}_{1,m,i} \neq 0\}$$

$$\mathcal{N}_{0,s}(m) = \{i : \mathrm{H}_{0,s,m,i} \neq 0\}$$

that contain the positions of the non-zero entries of $\mathbf{H}_0$ and $\mathbf{H}_{1,s}$ for row $m$, respectively. Let $N_{1,i}(m)$ denote the $i$'th entry of $N_1(m)$ and $N_{0,s,i}(m)$ the $i$'th entry of $N_{0,s}(m)$. The generation of parity bit $p_m$ ($1 \leq m \leq M$) can be described by

$$p_m \equiv \sum_i H_{1,m,\mathcal{N}_{1,i}(m)} y_{t-1,\mathcal{N}_{1,i}(m)} + \sum_j H_{0,s,m,\mathcal{N}_{0,s,j}(m)} x_{t,\mathcal{N}_{0,s,j}(m)} \mod 2$$

Note that in principle every parity bit can be computed in parallel. At least $S$ parity bits can be computed in parallel by fetching blocks of S data bits and respective shifter circuits.

The encoded block or frame $\mathbf{x}_t$ may be modulated using a modulator 614 to yield a block of modulated transmit symbols. The modulated transmit symbols are then transmitted to the receiver 220 via the communication channel 230, which may be an optical communication channel in some embodiments. A demodulator 222 may extract reliability information, e.g. LLRs, for each symbol or bit of a received encoded block or frame.

Spatially coupled or LDPC convolutional codes may be decoded using a sliding window decoder 224 to recover the information sequences. The decoder 224 may operate on a window of w' copies of the row defining matrix [$\mathbf{H}_1\ \mathbf{H}_0$] corresponding to a window of $w' + \mu$ frames of reliability information. For faster convergence speed, the windowed decoding can be combined with the aforementioned row-decoding or layered decoding algorithm. The layered decoder continuously updates and refines the received LLR values in the decoding window with the goal to compute LLRs that approximate the MAP values. Note that example embodiments are not limited to the use of the layered decoding scheme but also other decoding schemes may be employed, which do not use an explicit a-posteriori memory. For example, a conventional flooding decoder does not need an a-posteriori memory, but rather needs extrinsic edge memories that play a similar role. The layered decoder continuously updates and refines the received reliability information (e.g. LLR values) in the decoding window with the goal to compute LLRs that approximate the MAP values.

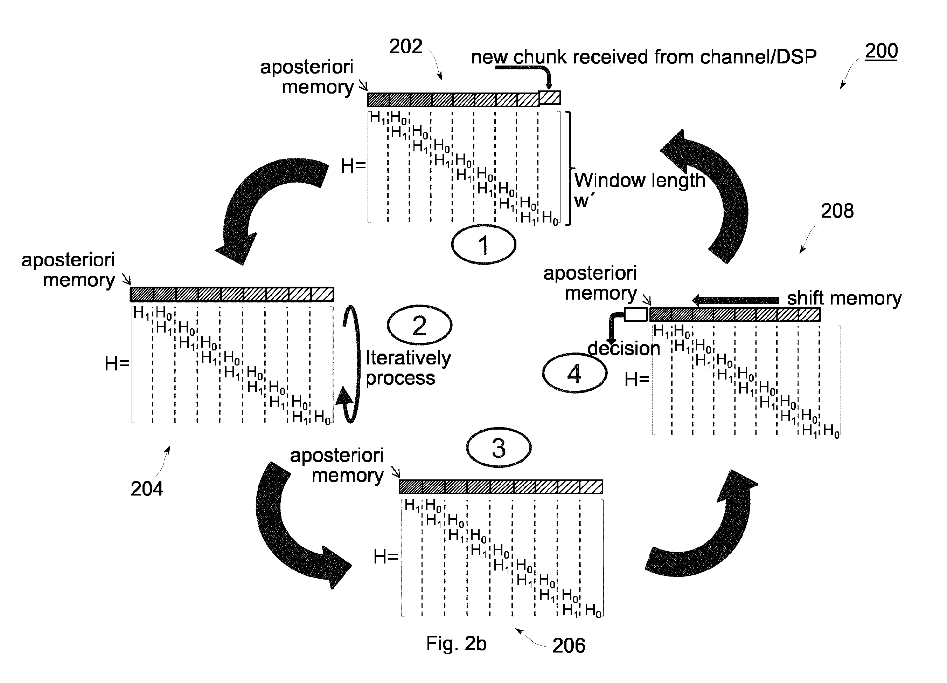

Four exemplary cycles of a windowed decoder 200 are depicted in **Fig. 2b** for an example with window size w = 8.

The windowed decoder 200 makes use of an a-posteriori memory of size $(w'+\mu)N$, with $N$= columns($\mathbf{H}_0$) = columns($\mathbf{H}_1$). In a first step 202 of the illustrated cycle a new chunk (size N) of received LLRs at time instant $t$ is received and inserted into an appropriate position of the decoder's a-posteriori memory. In a second step 204, a predefined number of decoder iterations may be executed making use of the row defining matrix [$\mathbf{H}_1\ \mathbf{H}_0$]. Note that the row decoder algorithm can be designed for this matrix [$\mathbf{H}_1\ \mathbf{H}_0$] and then can be reused by just accessing appropriately shifted memory locations. The different shades of grey in a third step 206 (as well as in the other steps) indicate reliabilities of different chunks of received LLRs in the a-posteriori memory. It can be observed that the reliabilities increase from right to left, i.e., the oldest values having received the highest number of updates, have the largest reliability. In a fourth step 208 of the cycle 200, the a-posteriori memory is shifted and the left-most LLR chunk is forwarded to a hard decision circuit in order to recover hypothetically transmitted symbols. After the shifting, there is now room for a new chunk that can be inserted in the first step 202 of the next cycle.

Note that the windowed decoding algorithm introduces a decoding delay of $w=w'+ \mu-1$ frames, such that at time instant $t$, we can recover the information frame $x'_{t-w'-\mu+1} = x'_{t-w}$. This is however of no issue in an optical communication system operating in a streaming fashion. Note that at the beginning of the transmission, an LDPC convolutional like encoder may be initialized with zeros at its second input. Thereby a second input may be dedicated to a delayed version of an encoded output signal, which may be fed back to a second encoder input. Hence, in the case of LDPC convolutional encoders the two inputs to the encoder at time instant t may be an input signal $\mathbf{x}_t$ (to be encoded) as well as the delayed (encoded) output signal $\mathbf{y}_{t-1}$ (and, if $\mu > 1$, $\mathbf{y}_{t-1}$, ..., $\mathbf{y}_{t-\mu}$). If the transmission starts at $t = 0$, this means that we set $\mathbf{y}_{-1}=0$. Accordingly, the memory of the decoder 200 may be initialized with perfect knowledge about the initial symbols being zero ($+\infty$).

Further, we consider a protograph-based construction of terminated spatially coupled (also commonly called terminated convolutional) LDPC codes. Thereby a protograph is a convenient way of describing certain sub-classes of LDPC codes. Protograph codes are constructed from a so-called $P$-cover of a relatively small graph which conveys the main properties of the code. The protograph serves as a blueprint for constructing LDPC codes of arbitrary size whose performance can be predicted by analyzing the protograph. A protograph can be any Tanner graph, typically one with a relatively small number of nodes. A protograph $G = (V, C, E)$ comprises a set of variable nodes $V$, a set of check nodes $C$, and a set of edges $E$. Each edge $e \in E$ connects a variable node $v_e \in V$ to a check node $C_e \in C$. Parallel edges are permitted, so the mapping $e \to (v_e, c_e) \in V \times C$ is surjective and thus not necessarily 1:1. This means that in contrast to the graph representation of the LDPC code, the protograph may contain multiple edges between variable and check nodes. The code itself is constructed by placing $P$ copies of the protograph next to each other (note that these have no interconnecting edges) and permuting the edges between the different copies of the protograph, such that the relation between the group of edges is respected.

This copy-and-permute operation for a protograph may be described by a protomatrix. An example of such a protomatrix is

$$\mathbf{B} = \begin{pmatrix} 1 & 2 & 0 \\ 2 & 1 & 3 \end{pmatrix}$$

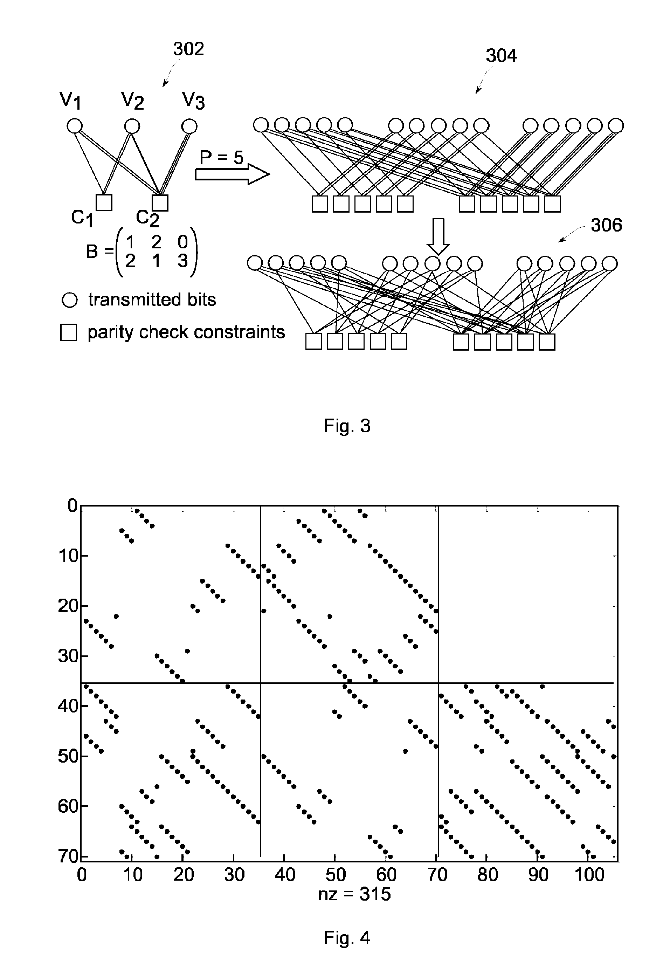

where the numbers or symbols in **B** denote the amount of parallel edges between the entries in the graph. Note that the permutation may be performed such that no parallel edges remain in the graph after permuting. Fig. 3 shows an example of the copy-and-permute operation for generating a graph with $P=5$ using the example protomatrix **B.**

In Fig. 3, reference numeral 302 denotes a template graph, i.e., the protograph, for the protomatrix **B.** According to the entries of the first row of **B** there is one edge connecting variable node $v_1$ to check node $c_1$. Two edges are connecting variable node $v_2$ with check node $c_1$. Zero edges are between variable node $v_3$ and check node $c_1$. According to the entries of the second row of **B** there are two edges connecting variable node $v_1$ to check node $c_2$. One edge is connecting variable node $v_2$ with check node $c_2$. Three edges are between variable node $v_3$ and check node $c_2$. Reference numeral 304 denotes the graph resulting of the copy-operation with $P=5$ using protomatrix **B.** Finally, reference numeral 306 denotes the graph resulting of the permute-operation based on graph 304.

Most LDPC codes that are implemented today are so-called Quasi-Cyclic (QC) LDPC codes. They have a parity-check matrix **H** with a structure that allows for inherent parallelization of an LDPC decoder and leads to an efficient encoder realization. Almost all LDPC codes utilized in practice belong to the class of QC-LDPC codes.

QC-LDPC codes may be constructed using a so-called lifting matrix **A.** The parity-check matrix H may be constructed from the lifting matrix **A** by replacing each element of **A** with either an all-zero matrix of size $S{\times}S$ or a permutation matrix, e.g., a cyclically permuted identity matrix, of size $S{\times}S$. We adhere to the following notation: $S$ denotes the lifting factor, i.e., the size of the all-zero or cyclically shifted identity matrix. If the entry of **A** at row $m$ and column $i$ corresponds to a predetermined value, e.g., $A_{m,i} = -1$, then the all-zero matrix of size $S{\times}S$ is used, and if $A_{m,i} \geq 0$, $A_{m,i}$ may denote how many cyclic right shifts of the identity matrix are performed. If dim(**H**) = $CxN$, then dim(**A**) = $C'{\times}N'$, with $C'=C/S$ and $N'=N/S$. We furthermore define the set $N_A (m)$ to denote the positions of the non "-1" entries (or any other entry denoting a void replacement) in the $m$-th row of **A,** i.e., $N_A (m) = \{i: A_{m,i} \neq -1\}$.

Let us illustrate the construction of QC-LDPC codes by a small (artificial) example with a lifting matrix of size dim(A) = 3x5 and a lifting factor of $S = 5$ (leading to dim(**H**) = $S{\cdot}$dim(**A**) = 15x25). This corresponds to a code of design rate $r = 0.4$, or an overhead of 150%, respectively).

$$\mathbf{A} = \begin{pmatrix} -1 & 0 & 1 & 1 & 2 \\ 2 & -1 & 4 & 2 & 1 \\ 1 & 3 & -1 & 3 & 1 \end{pmatrix} \rightarrow \mathbf{H} =$$

Note that for the sake of clarity again only non-zero entries are show in the description of **H**. Note that **H** represents a binary matrix. Generally the value $S$ corresponds to the parallelism that can be implemented in a QC-LDPC decoder.

In order to realize protograph-based QC-LDPC codes, we may employ a double-lifting procedure. First, from the protomatrix **B**, we may generate by the copy-and-permute operation a lifting matrix **A** and then optimize the non-void entries of **A** in order to get desired code properties. Using this lifting matrix **A**, we can then construct the parity-check-matrix **H** with the desired properties. We thus have dim(**H**) = $C''SP \times N''SP$, with dim(**B**)=$C'' \times N''$.

Let us illustrate the generation of an exemplary parity-check matrix **H** of a protograph-based QC-LDPC based on two-fold lifting by means of an example with $P=5$ and $S=7$. We start with the same exemplary protomatrix

$$\mathbf{B} = \begin{pmatrix} 1 & 2 & 0 \\ 2 & 1 & 3 \end{pmatrix},$$

which has been already introduced above and illustrated in Fig. 3. The $P=5$ cover shown in Fig. 3 of matrix **B** leads to a (parity-check) matrix **H'** that may be described by

$$\mathbf{H'} = \begin{pmatrix}
1 & & & & & 1 & 1 & & & & & \\
& & 1 & 1 & & & & 1 & & & & \\
& & 1 & 1 & & & & & 1 & & & \\
1 & & & & 1 & & & & 1 & & & \\
& 1 & & & & 1 & 1 & & & & & \\
\hline
1 & & & 1 & & & 1 & & 1 & 1 & 1 & \\
1 & & 1 & & & & & 1 & 1 & & 1 & 1 \\
& 1 & 1 & 1 & & & & & & 1 & 1 & 1 \\
1 & & & 1 & 1 & & 1 & 1 & 1 & & 1 & \\
& 1 & 1 & & & & 1 & & 1 & 1 & & 1
\end{pmatrix}.$$

The bipartite graph 306 of the matrix **H'** is shown in the bottom right corner of Fig. 3. Note that the $P \times P$ squares of **H'** are filled with non-overlapping superpositions of permutation matrices preserving the number of "1"s per row and column of each $P \times$ submatrix. Using the matrix **H'**, we can get the lifting matrix **A** by properly selecting the cyclic shifts. An exemplary lifting matrix **A** is

$$\mathbf{A} = \left(\begin{array}{ccccc|ccccc|ccccc}
-1 & 3 & -1 & -1 & -1 & -1 & 5 & 5 & -1 & -1 & -1 & -1 & -1 & -1 & -1 \\
-1 & -1 & -1 & -1 & 0 & 3 & -1 & -1 & 0 & -1 & -1 & -1 & -1 & -1 & -1 \\
-1 & -1 & -1 & 2 & -1 & 1 & -1 & -1 & -1 & 0 & -1 & -1 & -1 & -1 & -1 \\
6 & -1 & -1 & -1 & -1 & -1 & 6 & -1 & -1 & 3 & -1 & -1 & -1 & -1 & -1 \\
-1 & -1 & 6 & -1 & -1 & -1 & -1 & 4 & 2 & -1 & -1 & -1 & -1 & -1 & -1 \\
\hline
0 & -1 & -1 & -1 & 0 & -1 & -1 & 2 & -1 & -1 & 5 & 4 & 6 & -1 & -1 \\
4 & -1 & -1 & 1 & -1 & -1 & -1 & -1 & -1 & 1 & -1 & 2 & -1 & 0 & 5 \\
-1 & -1 & 1 & 0 & -1 & 0 & -1 & -1 & -1 & -1 & -1 & -1 & 6 & 6 & 6 \\
-1 & 4 & -1 & -1 & 0 & -1 & 4 & -1 & -1 & -1 & 2 & 0 & -1 & 6 & -1 \\
-1 & 2 & 1 & -1 & -1 & -1 & -1 & -1 & 5 & -1 & 0 & -1 & 0 & -1 & 3
\end{array}\right),$$

where the 1s of $\mathbf{H'}$ have been replaced by shift values in the range $\{0,1,...,S\text{-}1\}$ (here $S$=7) and the 0s (not shown in the description of $\mathbf{H'}$ for clarity) have been replaced by "-1". The resulting exemplary parity-check matrix $\mathbf{H}$ has dimension $2PS{\times}3PS = 70{\times}105$ and is visualized in Fig. 4, with the single dots representing the non-zero elements of the matrix.

In order to construct an exemplary spatially coupled protograph-based LDPC code used to achieve a channel utilization of approximately 0.5 bit/channel use (with BPSK transmission), for example, we may generate exemplary $\mathbf{H}_0$ and $H_1$ using the following exemplary protographs $\mathbf{B}_0$ and $\mathbf{B}_1$:

$$\mathbf{B}_0 = \begin{pmatrix} 2 & 1 \end{pmatrix}$$

$$\mathbf{B}_1 = \begin{pmatrix} 2 & 3 \end{pmatrix}$$

This may lead to the exemplary protograph $\mathbf{B}_{conv}$ defining an embodiment of a spatially coupled/convolutional LDPC code. Note that the right element of $\mathbf{B}_0$ is 1 in some embodiments.

$$\mathbf{B}_{conv} = \begin{pmatrix}
2 & 1 & & & & & & & \\
2 & 3 & 2 & 1 & & & & & \\
 & & 2 & 3 & 2 & 1 & & & \\
 & & & & 2 & 3 & 2 & 1 & \\
 & & & & & & 2 & 3 & 2 & 1 \\
 & & & & & & & \ddots & \ddots & \ddots & \ddots
\end{pmatrix}$$

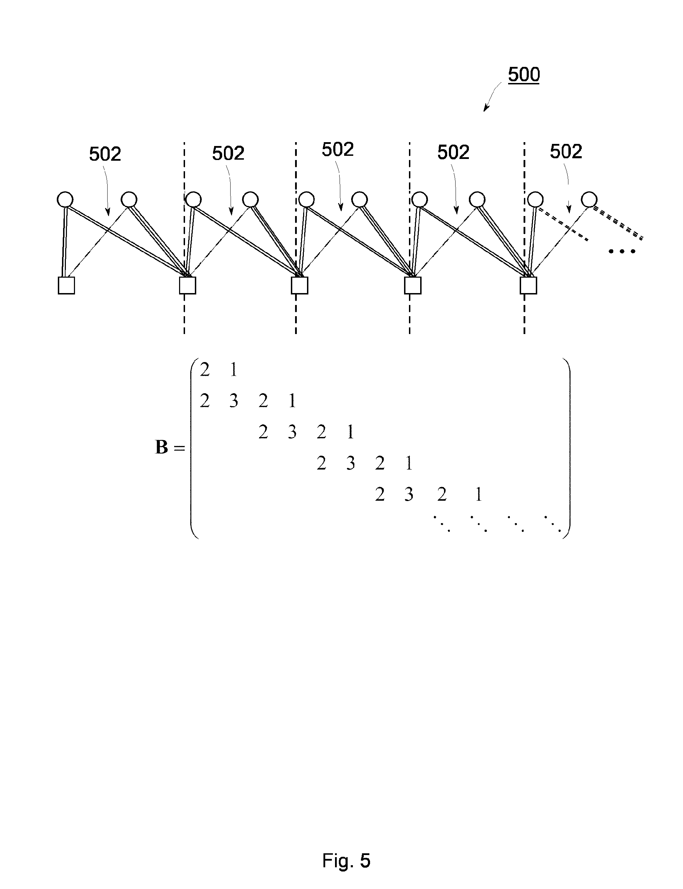

A protograph 500 corresponding to this exemplary protomatrix is shown in Fig. 5. The edges corresponding to a "1" in the protomatrix $\mathbf{B}_{conv}$ are marked by dashed lines 502 in Fig. 5. The reason for this is the following: We do not permute these edges in the copy-and-permute operation and in the lifting process to generate the QC-code. We replace these edges corresponding to a "1" in the protomatrix $\mathbf{B}_{conv}$ by an identity matrix. This structure may facilitate encoding.

Embodiments may be employed for higher-order modulation schemes. The terminology higher-order modulation scheme denotes a digital modulation scheme that maps a group of $V$ bits with $V > 1$ to a single modulation symbol that encodes the $2^V$ possible values of the group of bits. In digital modulation, an analog carrier signal may be modulated by a discrete signal. The changes in the carrier signal are chosen from a finite number of $M = 2^V$ alternative symbols defining the so-called modulation or symbol alphabet. In some embodiments, the digital modulation scheme may be a Quadrature Amplitude Modulation (QAM) scheme, such as 4-QAM, 8-QAM, 16-QAM, 32-QAM, 64-QAM, etc. Alternatively, the digital modulation scheme may be a Phase Shift Keying (PSK) scheme, such as QPSK, 8-PSK, 16-PSK, etc.

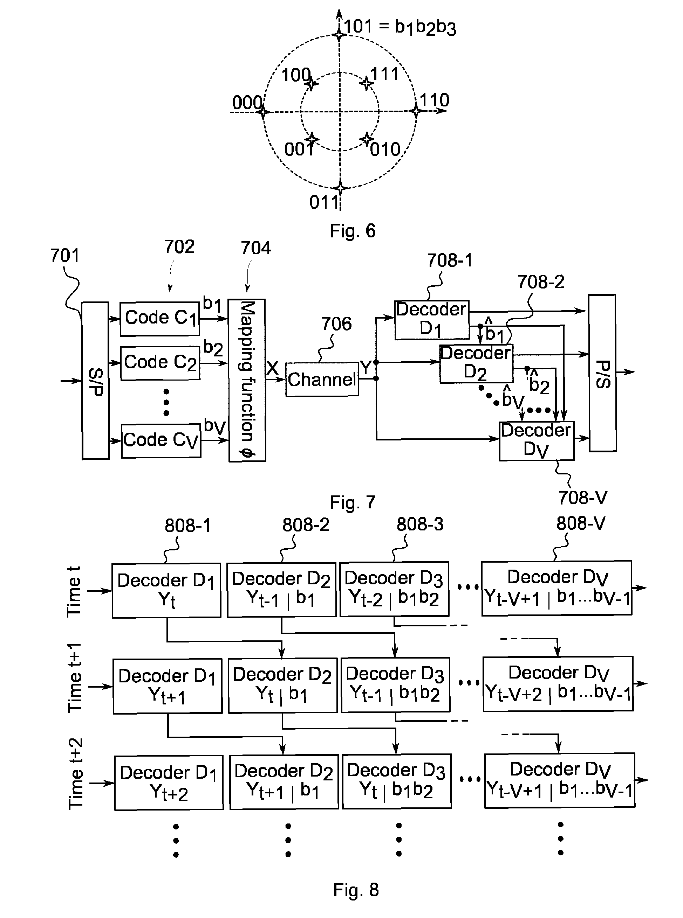

Let $V$ denote the number of bits per modulation symbol $X$, and let $\mathbf{b} = (b_1, b_2,..., b_V)$ be a binary $V$-tuple or address word. A one-to-one modulation mapping function $X = \varphi(b_1, b_2,..., b_V)$ maps b to a (complex) modulation symbol $X \in C$. As an example, Fig. 6 illustates a constellation diagram of a mapping function $X = \varphi(b_1, b_2, b_3)$ for an 8-Phase Asymmetric Phase Shift Keying (8-APSK) constellation. By decomposing the mutual information between channel input $X$ and channel output $Y \in C$ using the chain rule of mutual information $I$, we obtain

$I(X;Y) = I(b_1b_2 ...b_V; Y) = I(b_1; Y) + I(b_2; Y|b_1) + I(b_3; Y|b_1b_2) + ... + I(b_V; Y|b_1b_2 ...b_{V-1}).$ =: $C^{CM}$ This decomposition leads to an interpretation of the $V$-ary channel as $V$ equivalent binary channels. The chain rule decomposition supports a multi-level coding scheme with a multi-level coding encoder and a multi-stage decoder depicted in Fig. 7.

Each of the $V$ bits mapped to a constellation symbol $X$ is individually encoded by a component code $C_i$ of rate $R_{c,i}$ (702), mapped using $\varphi$ (704), and transmitted over a channel (706). A Serial-to-Parallel (S/P) converter 701 converts or partitions a block of source data bits into $V$ source data sub-blocks. The $i$-th source data sub-block may have $K_i$ source data bits. An encoding module or processor 702 encodes the $V$ source data sub-blocks with respective component codes $C_i$ ($i$ = 1, ..., $V$) to obtain $V$ encoded bit streams. The bits of the $V$ encoded bit streams form $V$-ary binary address words $\mathbf{b} = (b_1, b_2,..., b_V)$ where the bit $b_1$ is taken from the first encoded stream, the bit $b_2$ is taken from the second encoded stream and so on until finally, the bit $b_V$ is taken from the $V$'th encoded stream. We may conveniently assume that each of the streams can be partitioned into blocks of $N$ bits each. Using this partitioning, it is then customary to generate $N$ different address words $\mathbf{b}$ from the encoded streams, preferably taking bits from the same positions. A mapping module 704 maps, using a mapping function $\varphi$ ($b_1, b_2,..., b_V$), a binary address word b = ($b_1, b_2,..., b_V$) to a modulation symbol $X$ of an $M$-ary modulation scheme, wherein $M = 2^V$. Note that the mutual information $I(X; Y)$ between the modulation symbol $X$ and a transmission channel output $Y$ equals the mutual information $I(b_1, b_2 ..., b_V; Y)$ between the binary address word ($b_1, b_2,..., b_V$) and the transmission channel output $Y$.

At a receiver, a component decoder $D_1$ (708-1) may first recover the bit(s) $b_1$ and the associated information bit sequence, i.e., the first source data sub-block. Using the estimated value of $b_1$, a component decoder $D_2$ (708-2) can then recover $b_2$ and so on until $b_V$ is recovered based on $Y$ and the knowledge of $b_1, b_2,...,b_{V-1}$. Knowledge of $b_1, b_2,...,bi_{-1}$ at decoder $D_i$ means that the decoder $D_i$ only needs to consider $V / 2^{i-1}$ modulation symbols. With a set-partitioning mapping, for instance, the distances at each stage can then be increased. The task of a system designer is to select the rate $R_{c,i}$ of each single code $C_i$ such that the system performance is maximized.

At a first glance, the multi-stage decoder of Fig. 7 does not look too attractive due to the dependence of decoder $D_i$ ($i$ = 1, ..., $V$) on the $i$-1 previously decoded outputs. With a pipelined implementation, however, as shown in Fig. 8, the decoder utilization can be maximized and while decoder $D_2$ (808-2) decodes a frame from time instant $t$ with the knowledge of $b_1$, the decoder $D_1$ (808-1) can already compute a new frame at time instant $t$+1. However, $V$ different codes are needed for this system. Furthermore, the rates of the different codes can vary significantly and separate hardware for the $V$ distinct decoders needs to be provided.

Capacity-approaching codes that are currently in use in optical communications, such as block-turbo codes and LDPC codes, have the property that decoder complexity roughly scales with 1-$R_{c,i}$. The implementation of different codes of different rates with different encoders can be prohibitively complex in current and next-generation systems. The complexity of an LDPC decoder scales with the number of parity checks to be evaluated, i.e., with the overhead of the code. The goal of the system designer shall thus be to minimize the overhead of all codes employed in the system and to get a code rate distribution of the $V$ sub-codes that is as homogeneous as possible. Additionally, the memory requirements for the parallel decoding pipeline shown in Fig. 8 may be prohibitively large. On the other hand, if we consider future core networks with links that carry 1 Tb/s of data based on, e.g., 64-QAM modulation formats, multi-level coding may become an attractive alternative. For example, the scheme in F. Buchali et al., "1-Tbit/s dual-carrier DP 64QAM transmission at 64Gbaud with 40% overhead soft- FEC over 320km SSMF," in OFC/NFOEC, Anaheim, CA, 2013, uses two carriers, each carrying 500 Gb/s, where each carrier employs a dual-polarization 64-QAM. Instead of implementing two FEC engines (one for each carrier) operating at 500 Gb/s net data rate, it may be more advantageous with respect to a parallel implementation to have single FEC engines for the different bits of the constellation, each operating at a reduced net data rate (e.g., 42 Gb/s).

Hence, embodiments propose employing multi-level coding and multistage decoding. More particularly, some embodiments propose combining multi-level coding and multi-stage decoding with LDPC block and/or LDPC convolutional codes. An idea of embodiments is threefold: A first approach to decrease memory utilization is the use of a special bit mapping that reduces the memory consumption of a decoder's egress memories. Further aspects aim at reducing a decoder's ingress memories which need to store complex values. This may be achieved by optimization of the codes such that the decoding delays are minimized and/or by using hybrid schemes, where spatially coupled codes are combined with conventional block codes yielding an overall minimized memory usage.

The fact that spatially coupled codes are universally capacity-achieving makes them attractive for use in multi-level coding with multi-stage decoding as in this case, a capacity-achieving coding and modulation scheme can be implemented. However, the fact that the aforementioned and described windowed decoder introduces a decoding delay of $w$ frames, with $w = w' + \mu - 1$, such that at time instant $t$, we can only recover the information frame b'$_{t-w}$" poses some difficulties in using such codes in the multilevel-coding scheme.

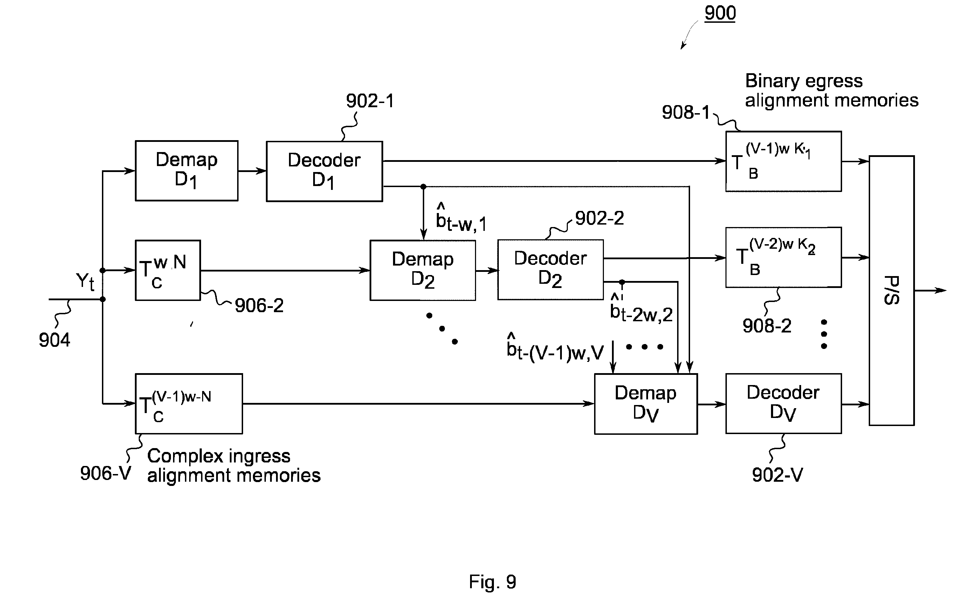

A component LDPC code $C_i$ responsible for coding bit $i$ may have a chunk size of $N$ (independent of $i$) and $K_i$ input bits, i.e., the rate may be $K_i/N$. A receiver 900 for the straightforward adaptation of multilevel coding with multi-stage decoding of channel output $Y_t$ at time instant $t$ is depicted in Fig. 9.

Receiver 900 comprises $V$ decoding stages 902-$i$ ($i$ = 1, ..., $V$), which may include LDPC block decoders and/or windowed LDPC convolutional decoders. We observe that in order to use a windowed decoder, we should delay the received IQ-samples 904 by $wN(i-1)$ in decoding stage $i$ ($i=1,...,V$). This means that

$$wN\sum_{i=1}^{V}(i-1)=\frac{1}{2}wN(V-1)V$$

complex memory locations are needed. These memories are illustrated as blocks 906-$i$ ($i$ = 1, ..., $V$) and denoted as complex ingress alignment memories in Fig. 9. If it is assumed that a complex received sample can be represented with $O$ bits (with $O/2$ being a quantizer resolution in either $I$ or $Q$ direction, usually $O/2$ = 3...6 bit), $wN(V-1)VO$ binary ingress memory locations are required. Additionally, at the end of the decoding branches some more delays to temporally re-align the decoded bit stream are required. These memories are illustrated as blocks 908-$i$ ($i$ = 1, ..., $V$) and denoted as binary egress alignment memories in Fig. 9. The binary egress alignment memories 908-$i$ ($i$ = 1, ..., $V$) require

$$w\sum_{i=1}^{V}K_i(V-i)$$

binary memory locations.

In the following, some schemes to improve the memory efficiency of the multi-level coding scheme using spatially coupled codes are described. The multi-level coding approach has the advantage that the scheme is capacity achieving independently of the chosen bit mappings. However, the rates of the different component or sub-codes $C_i$ ($i$ = 1, ..., $V$) in the $V$ branches depend on the selected bit mapping $\varphi$ ($b_1$, $b_2$,..., $b_V$). If it is assumed that capacity achieving (or approaching) codes can be implemented, then the rate $R_i = K_i/N$ of level $i$ should be chosen to be $R_i = I(b_i; Y|b_1,..., b_{i-1})$. That is to say, the rate $R_i$ should correspond to the mutual information of an equivalent transmission channel $i$ for transmitting bit $b_i$ of the binary address word, provided that the bits $b_1,..., b_{i-1}$, are known. The amount of required egress memory 908 is thus with this assumption

$$w\sum_{i=1}^{V}K_i(V-i)=wN\sum_{i=1}^{V}(V-i)R_i \rightarrow \min.$$

If we want to minimize a multistage decoder's binary egress alignment memory 908, an optimum bit mapping function $\varphi_{opt}$ ($b_1$, $b_2$,..., $b_V$) should be selected such that

$$\varphi_{opt}=\arg\min_{\varphi}\sum_{i=1}^{V}(V-i)I(b_i;Y\,|\,b_1,...,b_{i-1})\,,$$

which is equivalent to

$$\varphi_{opt}=\arg\min_{\varphi}\sum_{i=1}^{V-1}(V-i)I(b_i;Y\,|\,b_1,...,b_{i-1}) \qquad\qquad (*),$$

as the decoding branch assigned to level $V$ does not require any egress memory at all. In the following, several ways are described for determining and optimizing the bit mapping.

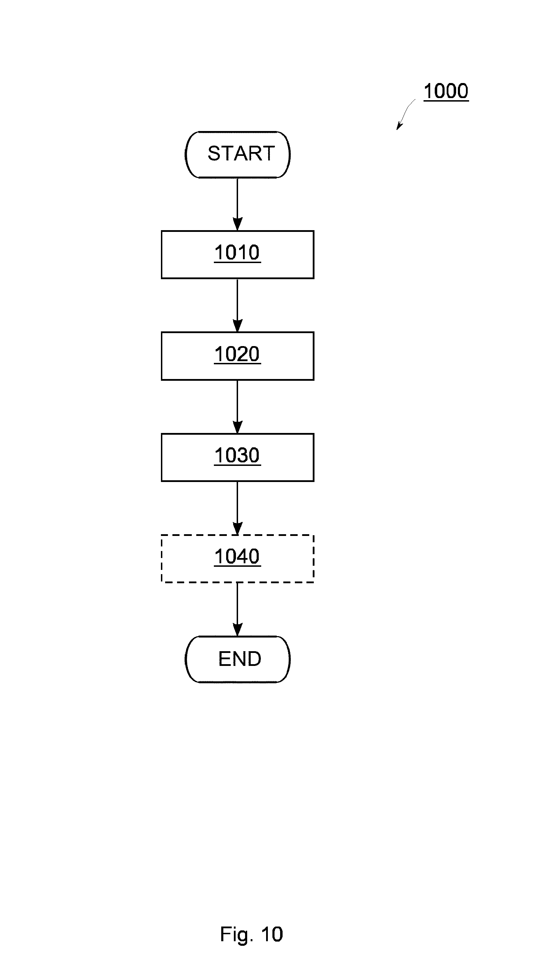

Hence, according to one aspect of the present disclosure, a multilevel encoding concept is provided. The multilevel encoding concept includes a multilevel encoding method 1000 as well as a multilevel encoding apparatus for performing said method. While a block diagram of the respective multilevel encoding apparatus is illustrated in Fig. 7, a flow-chart of the method 1000 is schematically illustrated in Fig. 10.

Method 1000 includes an act 1010 of partitioning or converting a block of source data bits into $V$ source data sub-blocks, as has already been described with reference to Fig. 7. In act 1020, the $V$ source data sub-blocks are encoded with a respective component code $C_i$ ($i = 1, ..., V$), e.g., an LDPC block or LDPC convolutional code, to obtain $V$ encoded bit streams. Bits of the $V$ encoded bit streams form $V$-ary binary address words ($b_1, b_2,..., b_V$). The first bit $b_1$ of the binary address word originates from encoding the first source data sub-block with component code $C_1$, the second bit $b_2$ of the binary address word originates from encoding the second source data sub-block with component code $C_2$, etc. The $V$-th bit $b_V$ of the binary address word originates from encoding the $V$-th source data sub-block with component code $C_V$. Further, method 1000 includes an act 1030 of mapping a binary address word ($b_1, b_2,..., b_V$) to a modulation symbol $X$ of an $M$-ary (e.g., $M = 2^V$) modulation scheme by using a predetermined mapping function $\varphi$ ($b_1, b_2,..., b_V$). According to information theory, the mutual information $I(X; Y)$ between the modulation symbol $X$ and a transmission channel output $Y$ equals the mutual information $I(b_1, b_2,..., b_V; Y)$ between the binary address word ($b_1, b_2,..., b_V$) and the transmission channel output $Y$. According to embodiments, the selected predetermined mapping function minimizes the expression $\sum_{i=1}^{V}(V-i)I(b_i ; Y|b_1, ..., b_{i-1})$ for a plurality of possible mapping functions. In the latter expression $I(b_i; Y|b_1, ..., b_{i-1})$ denotes the mutual information of an equivalent transmission channel $i$ for transmitting bit $b_i$ of the binary address word, provided that the bits $b_1, ..., b_{i-1}$ are known.

Optionally, method 1000 may further include an act 1040 of transmitting the modulation symbol $X$ over a transmission channel, which may be an optical channel, such as a fiber, for example. For example, the modulation symbol $X$ may be used to modulate a carrier signal, such as an optical signal or an RF signal.

In one embodiment, encoding 1020 the $V$ source data sub-blocks may comprise encoding each source data sub-block with a respective LDPC convolutional code having a syndrome former memory $\mu \geq 1$. That is to say, each of the different sub-codes $C_i$ ($i = 1, ..., V$) may be an LDPC convolutional code.

In another embodiment, encoding 1020 the $V$ source data sub-blocks may comprise encoding at least a first of the $V$ source data sub-blocks with at least a first LDPC block code to obtain at least a first of the $V$ multilevel encoded bit streams. Further, encoding 1020 the $V$ source data sub-blocks may comprise encoding at least a second of the $V$ source data sub-blocks with at least a second LDPC convolutional code to obtain at least a second of the $V$ multilevel encoded bit streams. That is to say, some embodiments suggest multilevel encoding based on using both LDPC block and LDPC convolutional codes. For example, LDPC block codes may be used to encode binary digits of "lower" levels, while LDPC convolutional codes may be used to encode binary digits of "higher" levels. Referring to Fig. 7, the component code $C_1$ may be an LDPC block code, for example, while the remaining component codes $C_2$ to $C_V$ are LDPC convolutional codes.

In one or more embodiments, method 1000 includes, prior to mapping 1030 the binary address word ($b_1, b_2,..., b_V$) to the modulation symbol $X$, determining $\sum_{i=1}^{V}(V-i)I(b_i ; Y|b_1, ..., b_{i-1})$ for the plurality of possible mapping functions, respectively. Then the minimum is determined among the respective determined expressions. The mapping function corresponding to the minimum expression is then selected as the predetermined mapping function. In some embodiments, the expression $\sum_{i=1}^{V}(V-i)I(b_i ; Y|b_1, ..., b_{i-1})$ may be determined and minimized for all $M!$ possible mapping functions, respectively. The latter acts can be performed by accordingly configured processing circuitry.

In the following it is described how the mutual information $I(b_i; Y | b_1,...b_{i-1})$ may be determined. The mutual information measure can be used to optimize the constellation labeling, i.e., the mapping of bit patterns ($b_1, b_2,..., b_V$) to constellation symbols $X$. We introduce the following notation to describe the computation of the mutual information. First, we denote the set of constellation symbols by $C$, which contains $M = 2^V$ symbols. For the exemplary 8-QAM constellation shown in Fig. 6, we have

$$C = \{1+1i, \quad -1+1i, \quad -1-i, \quad 1-1i, \quad 1+\sqrt{3}, \quad -1-\sqrt{3}, \quad (1+\sqrt{3})i, \quad (-1-\sqrt{3})i\}$$

where $i = \sqrt{-1}$ is the imaginary unit, used to describe complex numbers. Based on the mapping function $\varphi(.)$, which maps a $V$-ary bit-vector b to a (complex) modulation symbol $X \in C$ with $X = \varphi$ ($b_1, b_2,..., b_V$), we can define the mapping-dependent partial constellation sets. A partial constellation set $\overline{C}_{(b)}^{j}$ contains those constellation symbols that contain at the positions indicated by the vector **j** the values given by the binary vector **b.**

Let us illustrate with a few examples with respect to the constellation and mapping function shown in Fig. 6:

$$\overline{C}_{(0)}^{1} = \{1 - 1i, \quad -1 - 1i, \quad (-1 - \sqrt{3}), \quad (-1 - \sqrt{3})i\}$$

contains all the constellation points where the mapping function ensures that $b_1=0$, i.e., where the first bit associated to the constellation symbol is 0. Furthermore, we have

$$\overline{C}_{(0,1)}^{1,2} = \{1 - 1i, \quad (-1 - \sqrt{3})i\}$$

which contains all those constellation points where the bits $b_1 b_2$ take on the value (0,1), i.e., $b_1=0$ and $b_2=1$. Other partial constellations can be defined in a similar way. Note that in the following, we exemplarily assume that $P(X=x) = 2^{-V}$, i.e., all constellation symbols occur with equal probability. This corresponds to having $P(b_j=1) = P(b_j=0) = \frac{1}{2}$. Using the partial constellations, we can express the mutual information $I(b_1;Y)$ as follows

$$I(b_1;Y) = \frac{1}{2^V} \sum_{b=0}^{1} \int_{-\infty}^{\infty}\int_{-\infty}^{\infty} \left[ \sum_{y \in \overline{C}_{(b)}^1} p(z_I + iz_Q \mid y) \right] \cdot \log_2 \left( \frac{2 \sum\limits_{y \in \overline{C}_{(b)}^1} p(z_I + iz_Q \mid y)}{\sum\limits_{y \in C} p(z_I + iz_Q \mid y)} \right) \mathrm{d}z_I \mathrm{d}z_Q$$

where the integration is over the complex plane and $p(z_I + iz_Q \mid y)$ denotes the conditional channel transition probability, which, in the case of an AWGN channel with complex Gaussian noise with variance $N_0$ is given by

$$p(z_I + iz_Q \mid y) = \frac{1}{\sqrt{\pi N_0}} \exp\left( -\frac{|z_I + iz_Q - y|^2}{N_0} \right) ,$$

leading to

$$I(b_1;Y) = \frac{1}{\sqrt{\pi N_0} 2^V} \sum_{b=0}^{1} \int_{-\infty}^{\infty}\int_{-\infty}^{\infty} \left[ \sum_{y \in \overline{C}_{(b)}^1} \exp\left( -\frac{|z_I + iz_Q - y|^2}{N_0} \right) \right] \cdot \log_2 \left( \frac{2 \sum\limits_{y \in \overline{C}_{(b)}^1} \exp\left( -\frac{|z_I + iz_Q - y|^2}{N_0} \right)}{\sum\limits_{y \in C} \exp\left( -\frac{|z_I + iz_Q - y|^2}{N_0} \right)} \right) \mathrm{d}z_I \mathrm{d}z_Q$$

Hence, in one embodiment, determining the minimum of the expression $\sum_{i=1}^{V}(V-i)I(b_i;Y\mid b_1,\dots,b_{i-1})$ includes modelling the transmission channel 706 as an AWGN channel. This may be particularly useful for optical transmission channels, which are often assumed to be AWGN channels. In case of wireless communications, for example, other channel models, such as the Rayleigh channel model, may be of relevance. If other channel models are used, the probability density function $p(z_I + iz_Q \mid y)$ has to be modified accordingly.

The computation of $I(b_2; Y \mid b_1)$ may be obtained by computing the average over the possible values of the (given) bit $b_1 \in \{0,1\}$

$$I(b_2;Y \mid b_1) = \frac{1}{2^V} \sum_{b_1=0}^{1} \sum_{b=0}^{1} \int_{-\infty}^{\infty}\int_{-\infty}^{\infty} \left[ \sum_{y \in \overline{C}_{(b_1,b)}^{1,2}} p(z_I + iz_Q \mid y) \right] \cdot \log_2 \left( \frac{2 \sum\limits_{y \in \overline{C}_{(b_1,b)}^{1,2}} p(z_I + iz_Q \mid y)}{\sum\limits_{y \in C} p(z_I + iz_Q \mid y)} \right) \mathrm{d}z_I \mathrm{d}z_Q$$

or more specifically, if AWGN noise is used by

$$I(b_2;Y|b_1) = \frac{1}{\sqrt{\pi N_0}\, 2^V} \sum_{b_1=0}^{1}\sum_{b=0}^{1}\int_{-\infty}^{\infty}\int_{-\infty}^{\infty}\left[\sum_{y\in \overline{C}_{(b_1,b)}^{1,2}}\exp\left(-\frac{|z_I+iz_Q-y|^2}{N_0}\right)\right]\cdot\log_2\left(\frac{2\sum_{y\in \overline{C}_{(b_1,b)}^{1,2}}\exp\left(-\frac{|z_I+iz_Q-y|^2}{N_0}\right)}{\sum_{y\in C}\exp\left(-\frac{|z_I+iz_Q-y|^2}{N_0}\right)}\right)\mathrm{d}z_I\mathrm{d}z_Q$$

Note that the summation over the partial constellation is modified due to the knowledge of not only a single, but two bits. In the general case, we have

$$I(b_j;Y|b_1,\ldots,b_{j-1}) = \frac{1}{2^V}\sum_{b_1=0}^{1}\cdots\sum_{b_{j-1}=0}^{1}\sum_{b=0}^{1}\int_{-\infty}^{\infty}\int_{-\infty}^{\infty}\left[\sum_{y\in \overline{C}_{(b_1..b_{j-1}b)}^{1,...,j}}p(z_I+iz_Q|y)\right]\cdot\log\left(\frac{2\sum_{y\in \overline{C}_{(b_1..b_{j-1}b)}^{1,...,j}}p(z_I+iz_Q|y)}{\sum_{y\in C}p(z_I+iz_Q|y)}\right)\mathrm{d}z_I\mathrm{d}z_Q$$

which becomes in the case of AWGN noise

$$I(b_j;Y|b_1,\ldots,b_{j-1}) = \frac{1}{\sqrt{\pi N_0}\,2^V}\sum_{b_1=0}^{1}\cdots\sum_{b_{j-1}=0}^{1}\sum_{b=0}^{1}\int_{-\infty}^{\infty}\int_{-\infty}^{\infty}\left[\sum_{y\in \overline{C}_{(b_1..b_{j-1}b)}^{1,...,j}}\exp\left(-\frac{|z_I+iz_Q-y|^2}{N_0}\right)\right]\cdot\log_2\left(\frac{2\sum_{y\in \overline{C}_{(b_1..b_{j-1}b)}^{1,...,j}}\exp\left(-\frac{|z_I+iz_Q-y|^2}{N_0}\right)}{\sum_{y\in C}\exp\left(-\frac{|z_I+iz_Q-y|^2}{N_0}\right)}\right)\mathrm{d}z_I\mathrm{d}z_Q$$

Unfortunately, there is no simple closed-form solution for evaluating the mutual information $I(.;.)$, which is why one usually has to resort to numerical methods, e.g., the trapezoidal approximation in the Newton-Cotes quadrature rules or using Simpon's rule. The two-dimensional integration can be approximated by subsequent one-dimensional integration of both integrals, which is allowed by Fubini's theorem.

If, for example, the 8-APSK constellation shown in Fig. 6 is considered, an exhaustive computerized search over all possible 8! = 40320 possible bit mappings may be conducted to find the one minimizing the above cost function (*). While in some embodiments the search over the possible bit mappings, i.e., the determination of the predetermined mapping function may take place "offline", e.g., before performing the multilevel coding, it may also be performed "online", e.g., during performing the multilevel coding method 1000. The latter option may be interesting for rather small to medium-size modulation symbol alphabets $M$ and/or varying channel conditions.

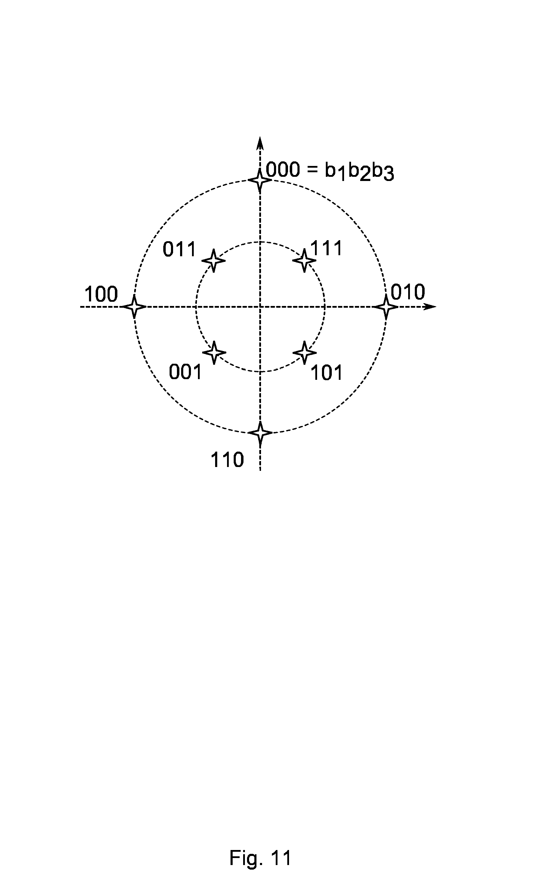

Let us assume that the target rate for the overall coding shall be 0.686, corresponding to an overhead of around 45%. It is assumed that the channel is corrupted with AWGN noise with $N_0 \approx 0.13$. The resulting mapping after the optimization is shown in Fig. 11 and it leads to a cost function of $\sum_{i=1}^{V}(V-i)I(b_i;Y|b_1,\ldots,b_{i-1}) = 1.538627$. The mapping shown in Fig. 6 has a (larger) cost function of 1.6837. The worst possible bit mapping for this constellation has a cost function of 2.1237. Thus, we can potentially reduce the binary memory requirements to realign the bit streams by around 27% by a properly selected mapping $X = \varphi(b_1, b_2, \ldots, b_V)$.

If higher order modulation formats with $V > 3$ are used, an exhaustive search trying all $2^V!$ possible bit mappings may become infeasible. Unfortunately, the optimization of the bit mapping to minimize (*) can be formulated as a Quadratic Assignment Problem (QAP), which are known to be Non-deterministic Polynomial-time hard (NP-hard). Therefore, we either have to evaluate all combinations, or use heuristic algorithms. For instance for 16-QAM, already $16! \approx 2 \cdot 10^{13}$ possible mappings (including symmetries) exist, which may make the full search infeasible. In this case, we may resort to combinatorial optimization algorithms that find at least a local optimum value (but not necessarily the global optimum). One such approach is for instance the Tabu-search algorithm, see R. Battiti and G. Tecchiolli, "The reactive tabu search," ORSA Journal on Computing, Vol. 6, pp. 126-140, 1994. The high-level routine of this algorithm is given by

1) Initialize constellation with random or deterministic initial mapping function $\phi$, initialize the Tabu-list by an empty list, initialize $f_{min} = \infty$ and $\phi_{best} \leftarrow \phi$

2) While criteria to abort optimization are not met, do

3) Try all possible $\binom{2^V}{2}$ combinations of two constellation points $y_1$ and $y_2$. Temporarily exchange the bit patterns assigned to $y_1$ and $y_2$ leading to the intermediate temporary bit mapping function $\phi_k$ followed by (numerically)

evaluating $\sum_{i=1}^{V-1} (V-i)I(b_i;Y\,|\,b_1,...,b_{i-1}) =: f_k$, where $k$ is a counter variable running from 1 to $\binom{2^V}{2}$.

4) For all possible $k$ between 1 and $\binom{2^V}{2}$, find the $k$ that leads to a mapping that is not in the tabu-list and that yields the smallest value of $f_k$, i.e.: $k = \arg\min f_k \,\substack{k=1,...,\binom{2^V}{2} \\ \phi_k \,\text{not in Tabu-list}}$

5) Set $\phi \leftarrow \phi_{\hat{k}}$. If $f_{\hat{k}} < f_{min}$ then additionally set $\phi_{best} \leftarrow \phi_{\hat{k}}$ and $f_{min} \leftarrow f_{\hat{k}}$. If the maximum number of entries of the tabu-list has not yet been reached, then add $\phi_{\hat{k}}$ to the tabu-list. Otherwise, replace the oldest entry of the tabu-list with $\phi_{\hat{k}}$.

6) Goto step 2)

Of course, this only one possible way to optimize the mapping. Other popular bit mapping optimization algorithms that are for instance frequently used in the optimization of bit mappings for BICM-ID (Bit-Interleaved Coded Modulation with Iterative Decoding) include the Binary Switching Algorithm (BSA), described in detail in F. Schreckenbach, Iterative Decoding of Bit-Interleaved Coded Modulation, PhD thesis, TU Munich, 2007 and originally developed for the optimization of bit patterns to the code vectors in vector quantization K. Zeger and A. Gersho, "Pseudo-Gray coding," IEEE Transactions on Communications, Vol. 38, pp. 2147-2158, December 1990. Other methods to solve the QAP problems include branch-and-bound algorithms (yielding exact solution but slow) or the greedy algorithm (heuristic), which tries to sequentially assign the $2^V$ bit patterns to the modulation symbols, maximizing an intermediate cost after each of the $2^V$ steps.

Depending of the utilized codes, it may happen that not all decoders $D_i$ ($i$ = 1, ..., $V$) are implemented with the same window length. Usually, a system designer aims at minimizing a window length $w_i$ ($i$ = 1, ..., $V$) such that a certain target Bit Error Rate (BER) may be achieved for a target Signal-to-Noise Ratio (SNR or $E_s/N_0$ or $E_b/N_0$). As multilevel coding utilizes codes of different rates $R_i$, it is not necessarily useful to employ the same window length $w_i$ ($i$ =1, ..., $V$) for all the codes. Some codes may require decoders with smaller window size, other decoders may require larger window sizes. Usually, the upper level branches of the multilevel coding system need to be more reliable than the lowest level branch to prevent error propagation, such that usually $w_1 \geq w_2 \geq w_3 \geq ... \geq w_V$. If the window sizes are not all equal, the above cost function (*) may be modified to

$$\sum_{i=1}^{V} w_i K_i (V-i) = N \sum_{i=1}^{V} w_i (V-i) R_i \rightarrow \min$$

If we want to minimize the binary egress alignment memory 908, we may thus select or determine the bit mapping function such that

$$\varphi_{opt} = \arg\min_{\varphi} \sum_{i=1}^{V} w_i (V-i) I(b_i;Y\,|\,b_1,...,b_{i-1})$$

which is equivalent to

$$\varphi_{opt} = \arg\min_{\varphi} \sum_{i=1}^{V-1} w_i (V-i) I(b_i;Y\,|\,b_1,...,b_{i-1}) \qquad\qquad (**)$$

There is however an inherent problem with the optimization of (\*\*). The joint optimization of $w_i$ and $I(b_i; Y | b_1, ..., b_{i-1})$ is inherently complicated, but we may assume that the $w_i$ are predefined by the system setup.

Note that the following embodiments are not limited to spatially coupled codes but can be used for any coding scheme where the decoder of the single decoding branches or stages induces a certain decoding delay.

In the previously presented embodiments we have seen an approach to decrease the size of the binary egress memory 908 by properly selecting the binary bit mapping $X = \varphi(b_1, b_2,..., b_V)$ of the multilevel coding scheme. In following embodiments, which can be combined with previous embodiments, the focus is on the complex ingress memory 906. As it can be seen in Fig. 9, the size of the complex ingress memory 906 depends on the window size $w$ and on the block size $N$ of a single chunk or frame. In order to decrease the size of this memory units 906, we either have to select $N$ small, or choose a (component) code $C_i$ that can be decoded with a small window size $w_i$. The latter approach can be realized using rapidly converging codes as presented in V. Aref, L. Schmalen, and S. ten Brink, "On the Convergence Speed of Spatially Coupled LDPC Ensembles," Allerton Conference 2013, which by properly optimized degree distributions can be decoded using a limited number of iterations implying also a limited window size $w$.

The good performance of spatially coupled codes necessitates unfortunately a large value $N$. If $N$ is decreased, we have to increase the equivalent syndrome former memory $\mu$ on the other hand to maintain the good performance of the code. This value $\mu$ has however also a direct implication on the required window size $w$ of the decoder. In what follows, we now assume that each branch $i$ ($i = 1, ..., V$) may be realized using decoders that have different window sizes and we denote the individual window sizes by $w_i$. We thus may optimize the code parameters such that for each code the minimum window length results and such that

$$\sum_{j=1}^{V-1} \sum_{i=1}^{j} w_i = \sum_{j=1}^{V-1} (V-j) w_j \rightarrow \min \qquad (***)$$

is minimized while maintaining an acceptable communication performance, e.g., achieving a required Bit Error rate (BER) for a given threshold channel condition.

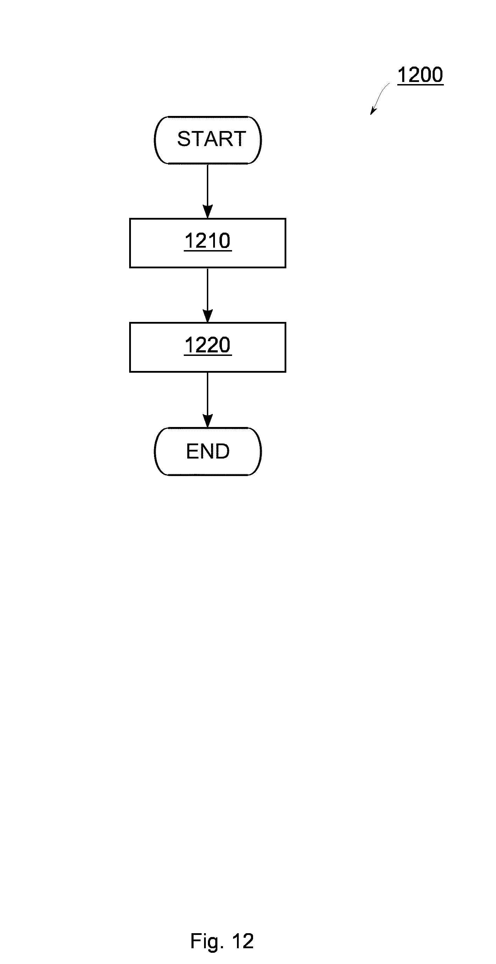

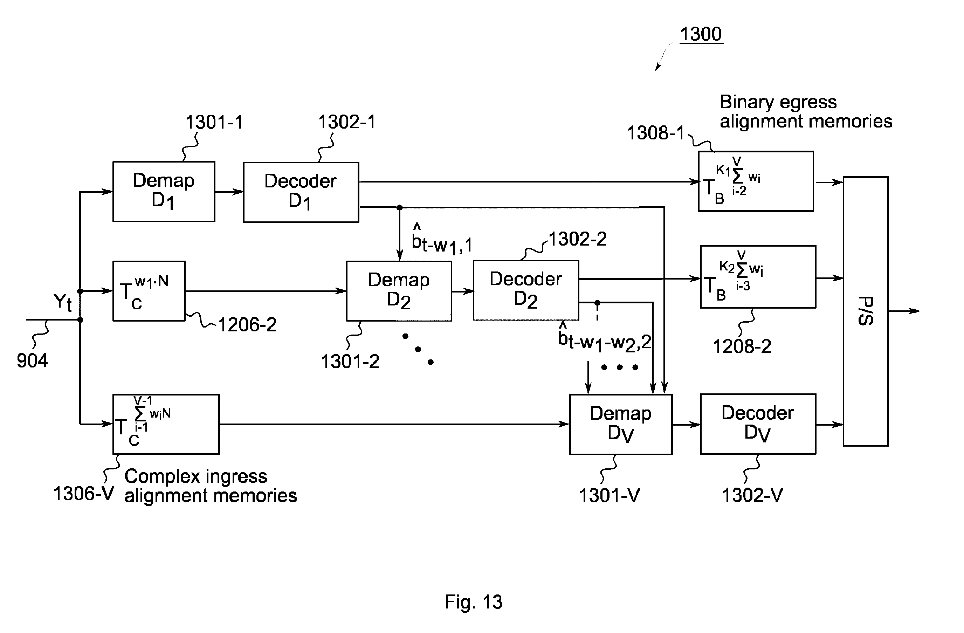

According to a further aspect of the present disclosure, a multistage decoding concept is provided. The multistage decoding concept includes a multistage decoding method 1200 as well as a multistage decoding apparatus 1300 for performing said method. While a block diagram of the respective multilevel encoding apparatus is illustrated in Fig. 13, a flow-chart of the method 1200 is schematically illustrated in Fig. 12.

The method 1200 includes an act 1210 of using a first windowed decoder stage 1302-1 operating on a window of $w_1$ copies of a submatrix, e.g., a row-defining matrix, defining a first parity-check matrix of a first LDPC convolutional code to decode, in accordance with a first LDPC decoding rule based on the first parity-check matrix, one or more first data bits $\hat{b}_{t-w_1,1}$ of a first bit stream encoded with the first LDPC convolutional code. The first bit stream is one of $V \geq 2$ encoded bit streams. The multistage decoding method 1200 further includes an act 1220 of using the decoded one or more first data bits $\hat{\boldsymbol{b}}_{t-w_1,1}$ as input for at least a second windowed decoder stage 1302-2 operating on a window of $w_2$ copies of a submatrix defining a second parity-check matrix of a second LDPC convolutional code to decode, in accordance with a second LDPC decoding rule based on the second parity-check matrix, one or more second data bits $\boldsymbol{b}_{t-w_1-w_2,2}$ of a second bit stream encoded with the second LDPC convolutional code. Also the second bit stream is one of the $V$ encoded bit streams. Note that the decoder stage 1302-1 in the multistage decoder 1300 is not a pure LDPC convolutional decoder but a combination of a demodulator 1301-1 and a decoder. The demodulator carries out the act of demapping, i.e., converting the received complex signal space points $y_i$ into V log-likelihood ratios, which is described in what follows. In the demodulator of the first branch, no other bits are yet known, and the demodulator carries out a demapping procedure on the full constellation and the equation to compute the log-likelihood ratio $L(y_1)$ of the first bit associated to the first branch given the received complex value y by

$$L(y_1) = \log \left( \frac{\sum_{\tilde{y} \in \overline{C}_{(0)}^1} p(y | \tilde{y})}{\sum_{\tilde{y} \in \overline{C}_{(1)}^1} p(y | \tilde{y})} \right)$$

Similarly, for the second branch, where we know the bit value $b_1$ we may compute

$$L(y_1 \mid b_1) = \log\left( \frac{\sum\limits_{\tilde{y} \in C^{1,2}_{(b_1,0)}} p(y \mid \tilde{y})}{\sum\limits_{\tilde{y} \in \overline{C}^{1,2}_{(b_1,1)}} p(y \mid \tilde{y})} \right)$$

using the partial constellation set. Similarly, the LLRs of the other branches may be computed. These LLRs can then be fed into the row-layered windowed decoder, for example. If the channel is assumed to be an AWGN channel with complex Gaussian noise with variance $N_0$, then we may replace $p(y|\tilde{y})$ **by**

$$p(y \mid \tilde{y}) = \frac{1}{\sqrt{\pi N_0}} \exp\left( -\frac{|y - \tilde{y}|^2}{N_0} \right),$$

in the above equations.

In fact the bits $\hat{b}_{t\text{-}w_1,1}$ from the first decoder 1302-1 are actually not used in the second decoder 1302-2 itself, but in the demodulator/demapper part of this second combined decoder stage. In the multistage decoding method 1200, selecting sizes $w_1, \dots, w_V$ of the windows of the $V$ windowed decoders includes minimizing the expression $\sum_{j=1}^{V}(V - j)w_j$, while maintaining a Quality of Service (QoS) above a predefined threshold.

This may lead to an overall reduced memory consumption. This situation is shown in Fig. 13 where the window lengths $w_j$ of the individual decoders are minimized resulting in a minimization of (\*\*\*).

In one or more embodiments, method 1200 may further include receiving a transmission channel output signal $Y_t$. A modulation symbol of an $M$-ary modulation scheme may be estimated based on the transmission channel output signal $Y_t$. The estimated $M$-ary modulation symbol may be mapped, via demappers, to at least one bit of $V$-ary binary address word ($b_1, b_2 \dots, b_V$). The $i$-th bit $b_i$ of the binary address word may be inputted to the $i$-th decoder stage 1302-$i$.

In one embodiment the transmission channel is an optical channel. However, other channels, such as wireless fading channels, are also conceivable.

In one or more embodiments, the first LDPC decoding rule and/or the second LDPC decoding rule may be based on an iterative row-layered LDPC decoding rule.

In some embodiments, the first LDPC convolutional code and/or the second LDPC convolutional code may use a syndrome former memory $\mu \geq 1$, respectively.

In some embodiments, the multistage decoding method 1200 may further include using at least a further decoder stage to decode, in accordance with an LDPC block decoding rule, one or more first data bits of a further bit stream encoded with an LDPC block code. The LDPC block code may be used for bit streams of lower levels compared to the first and second LDPC convolutional codes, or vice versa.

The statement of (\*\*\*) is still very abstract and we now intend to present a more in-depth description. Note that the expression in (\*\*\*) could theoretically be minimized by setting all $w_j = 0$, however, in this case the constraint that "maintaining an acceptable communication performance" will most certainly not be fulfilled. This latter constraint can, e.g., be expressed in terms of the residual BER after decoding BER$_{\text{final}}$, which shall be conveniently below a pre-defined threshold $T_{\text{BER}}$ for a given value of channel signal-to-noise-ratio $E_s/N_0$.

The refined optimization problem thus reads

$$\text{minimize} \sum_{j=1}^{V-1} (V - j)w_j$$

$$\text{subject to } \text{BER}_{\text{final}}(w_1, \dots, w_{V-1}, E_s/N_0) < T_{\text{BER}}.$$

Thus, in some embodiments, maintaining the QoS above the predefined threshold includes keeping a decoded signal error rate at a given Signal-to-Noise Ratio (SNR) below a predefined error rate threshold.

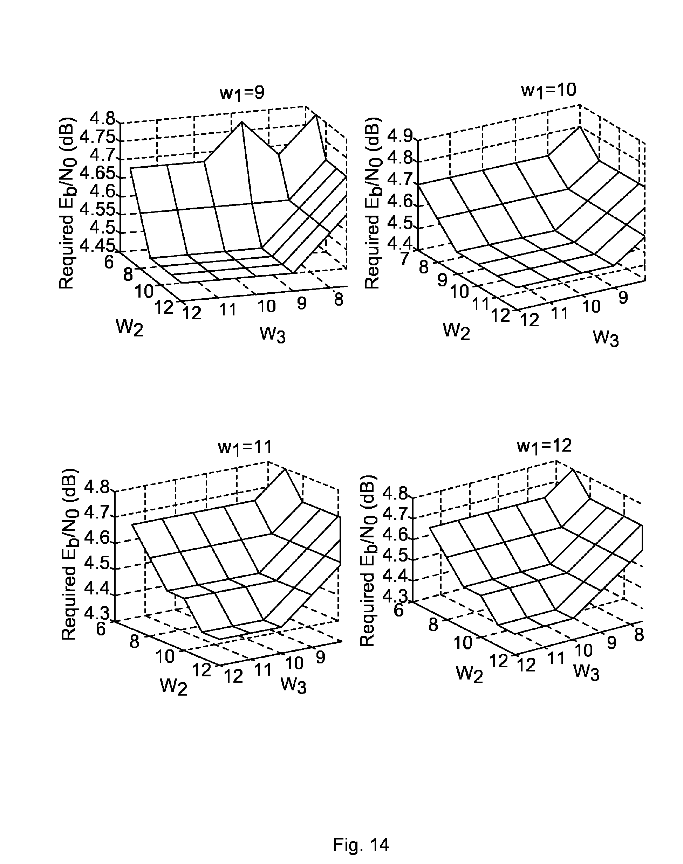

We illustrate the proposed concept by means of a simulation example. For this example, we utilize the 8-QAM constellation with the mapping function given in Fig. 6. We intend to achieve an overall coding rate of $R = 0.8$, which is achieved with this mapping by using sub-codes of rates $R_1 = R_2 = 0.8112$ and $R_3 = 0.7777$. These rates are found by varying the channel SNR such that $I(b_1;Y) + I(b_2;Y|b_1) + I(b_3;Y|b_1b_2) = 0.8$ results, e.g., obtained by a simple binary search. We constructed irregular spatially coupled LDPC codes with $\mu = 1$ and used a decoder based on row-layered windowed decoder that carries out a single iteration per window step. We simulated the system performance for different system setups with $w_1$, $w_2$ and $w_3$ in the range $\{7,8,9,10,11,12\}$. In Fig. 14, we show for different values of $w_1$, $w_2$ and $w_3$ the required $E_b/N_0 = V \cdot R \cdot E_s/N_0$ to achieve a bit error rate of $10^{-6}$ after decoding. We aim in this example at providing a reliable communication up to a value of $E_b/N_0 < 4.55$ dB. This means that we want to minimize the cost $2w_1 + w_2$ such that a BER of $10^{-6}$ is achieved for an $E_b/N_0$ that is smaller than the threshold of $T_{BER} = 4.55$ dB. We find that this is the case of $w_1 = w_2 = 9$ (see upper-left part of Fig. 14) and $w_3 > 9$ (note that the example cost function does not depend on $w_3$). From this, we might choose $w_3 = 9$ to minimize the required amount of egress memory 1308. If the egress-memory optimized mapping from Fig. 11 is used, we get $R_1 = 0.6295$, $R_2 = 0.7766$ and $R_3 = 0.9941$ and a similar optimization can be used.

A further possibility is to jointly optimize the ingress and egress memories 1306, 1308 for a given mapping function $\varphi (b_1, b_2,..., b_V)$. In order to provide an equation for optimizing the mappings, we introduce the overhead factor $O$ which describes the factor by which each memory cell of the ingress complex memory 1306 is larger than a cell of the binary egress memory 1308. For instance, if each complex number is saved using two 16-bit floating point numbers, the factor amounts $O = 2 \cdot 16 = 32$. In that case, we can formulate the total amount of memory needed to be

$$NO\sum_{j=1}^{V-1}\sum_{i=1}^{j} w_i + \sum_{j=1}^{V-1} K_j \sum_{i=j+1}^{V} w_i = N\sum_{j=1}^{V-1}\left( O\sum_{i=1}^{j} w_i + R_i \sum_{i=j+1}^{V} w_i \right) \quad \rightarrow \quad \min$$

Which, for fixed $N$, is equivalent to

$$\sum_{j=1}^{V-1}\left( O\sum_{i=1}^{j} w_i + R_i \sum_{i=j+1}^{V} w_i \right) \quad \rightarrow \quad \min$$

which can be minimized. Hence, in some embodiments, minimizing the expression $\sum_{j=1}^{V}(V-j)w_j$ may include minimizing the expression $\sum_{j=1}^{V-1}\left( O\sum_{i=1}^{j} w_i + R_i \sum_{i=j+1}^{V} w_i \right)$. Here, $O$ may denote a factor related to a bit-width of information to be stored in a decoder memory. $R_i$ may denote a coding rate of the $i$-th component LDPC convolutional code.

Again, we can employ a similar routine as above and find the best possible selection of $w_i$. For the example that we had above with the mapping of Fig. 6, and assuming $O = 8$ (every complex value is quantized to two fixed-point 4-bit values), we get with $V = 3$ that with $w_1 = w_2 = w_3 = 9$, the cost function $\sum_{j=1}^{V-1}\left( O\sum_{i=1}^{j} w_i + R_i \sum_{i=j+1}^{V} w_i \right) = 237.9024$ is minimized leading to the overall smallest number of (ingress and egress) memories 1306, 1308. The following table summarizes example optimum values of $w_1$, $w_2$ and $w_3$ for different target $E_b/N_0$ values.

| Target $E_b/N_0$ (dB) | w1, w2, w3 | $\sum_{j=1}^{V-1}\left( O\sum_{i=1}^{j} w_i + R_i \sum_{i=j+1}^{V} w_i \right)$ |
|---|---|---|
| 4.45 dB | 11,11,10 | 289.1472 |
| 4.55 dB | 9, 9, 9 | 237.9024 |
| 4.65 dB | 8,8,8 | 211.4688 |

Finally, a third scheme is proposed realizing a hybrid multi-level coding scheme where the first $V$-$T$ encoders are conventional block codes and the last $T$ decoders are spatially coupled codes with windowed decoders that are configured to employ windows of length $w_i$.

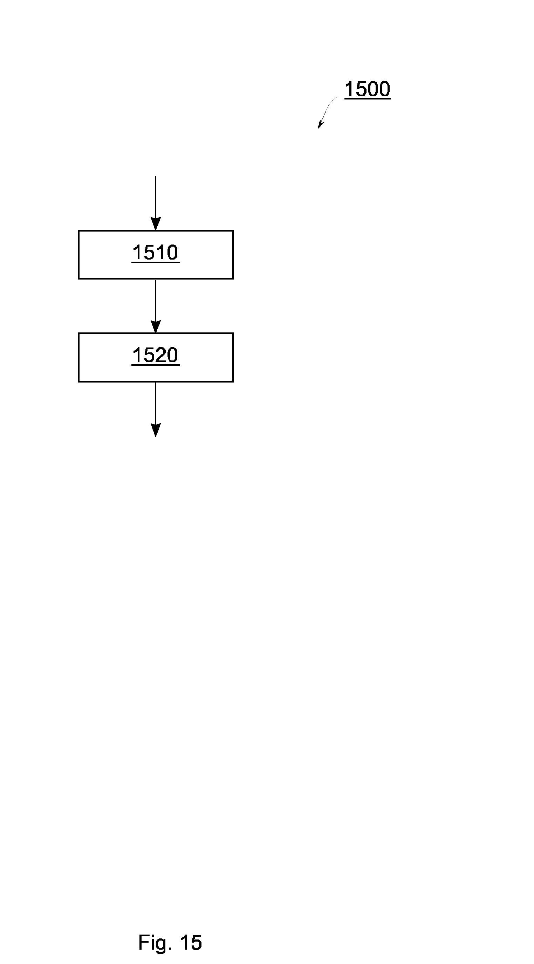

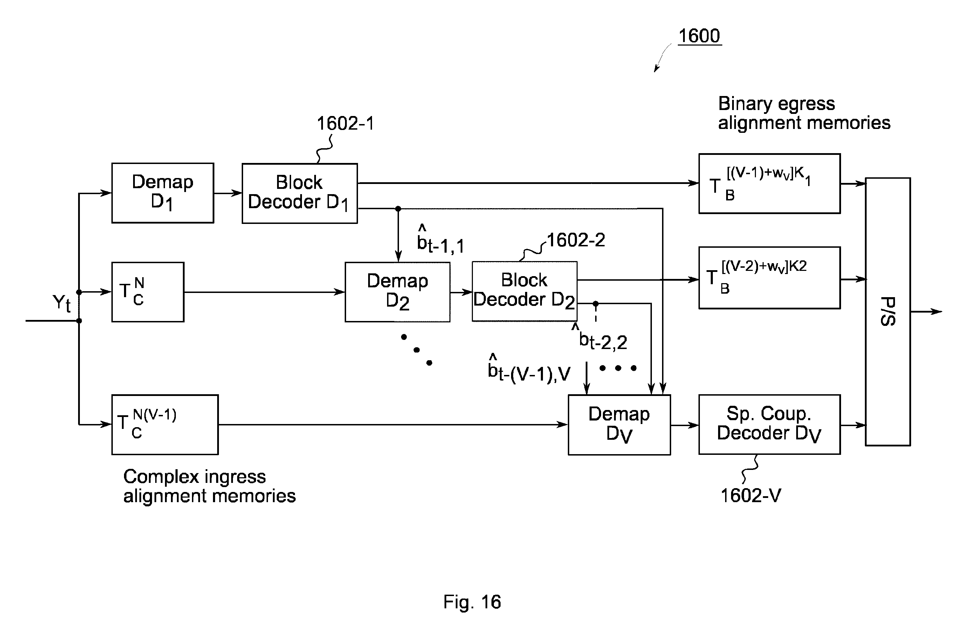

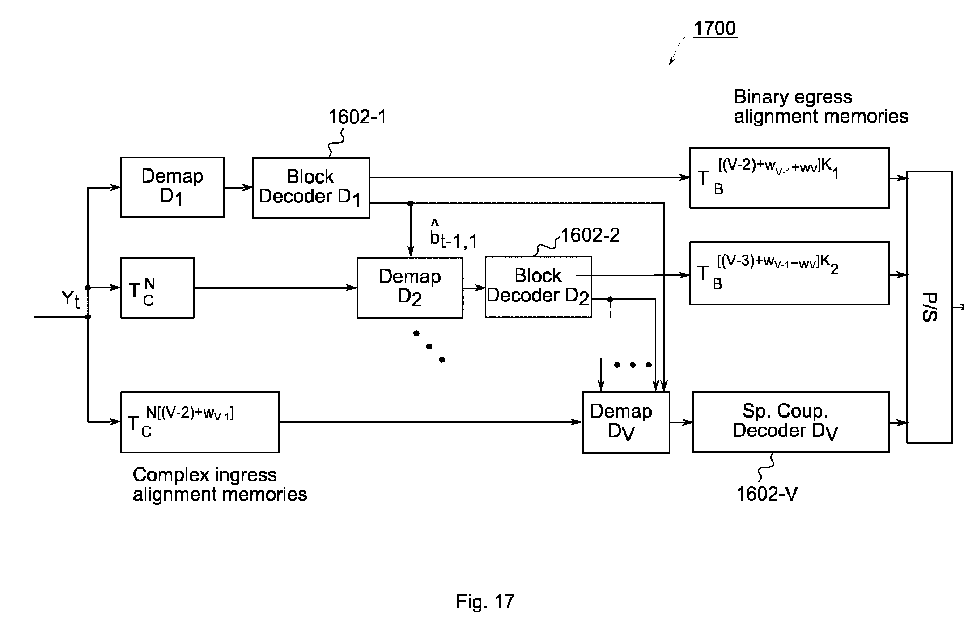

According to a further aspect of the present disclosure, it is provided a further multistage decoding concept. The multistage decoding concept includes a multistage decoding method 1500 as well as a multistage decoding apparatus for performing said method. While block diagrams of respective example multilevel encoding apparatuses are illustrated in Figs. 16 and 17, a flow-chart of the method 1500 is schematically illustrated in Fig. 15.

The decoding method 1500 includes an act 1510 of using a first decoder stage 1602-1 to decode, in accordance with an LDPC decoding rule based on a first parity-check matrix, one or more first data bits of a first bit stream encoded with an LDPC block code. The first bit stream is one of $V \geq 2$ multilevel encoded bit streams. Due to the LDPC block code no windowed decoder is required here. However, it may be assumed that the block decoder 1602-1 has a delay of 1 frame, i.e., has a corresponding $w_1 = 1$. In the embodiments of Figs. 16 and 17, the method 1500 also comprises an act of using at a second decoder stage 1602-2 to decode, in accordance with a second LDPC decoding rule based on a second parity-check matrix, one or more second data bits of a second bit stream encoded with an LDPC block code. The second bit stream is also one of the $V \geq 2$ multi-level encoded bit streams. Due to the LDPC block code, no windowed decoder is required here. Again, it may be assumed that the block decoder 1602-2 has a delay of 1 frame, i.e., has a corresponding $w_2 = 1$. The method 1500 further includes an act 1520 of using the decoded one or more first data bits as input for at least a further decoder stage 1602-V operating on a window of $w_V > 0$ copies of a submatrix defining a further parity-check matrix of an LDPC convolutional code to decode, in accordance with a further LDPC decoding rule based on the further parity-check matrix, one or more further data bits of a further bit stream encoded with the LDPC convolutional code. Also the further bit stream is one of the $V$ multilevel encoded bit streams.

In Fig. 16, an example decoder 1600 is shown for $T$=1 (only $T$=1 spatially coupled code used in the scheme). In Fig. 17, an example decoder 1700 is shown for $T$=2 ($T$=2 spatially coupled codes). We assume that the block decoder has a delay of 1 frame, i.e., has a corresponding $w$ of $w_{\text{BLOCK}}$ =1. This is accounted for in the decoders 1600, 1700, which have now decreased amounts of ingress and egress memories.

The optimizations mentioned in the aforementioned embodiments can of course still be applied after proper adaptation. In this case, the total amount of complex ingress memory amounts to

$$N \sum_{i=1}^{V-T} (i-1) + N \sum_{i=1}^{T} \left( (V - T) + \sum_{j=1}^{i-1} w_{V-T+j} \right),$$

which may be simplified to

$$N \left( -\frac{T^2}{2} + \frac{T}{2} + \frac{V^2}{2} - \frac{V}{2} + \sum_{i=1}^{T-1} (T-i) w_{V-T+1} \right),$$

where the first part of the expression may be assumed to be constant. The amount of required binary egress memory also needs to be adapted to account for the hybrid scheme. First we may assume that all $T$ LDPC convolutional decoders use windows of length w and all block decoders use windows of length 1. The total amount of binary egress memory thus is

$$N \left( \sum_{i=1}^{V-T} \left( (V - T - i) + Tw \right) R_i + w \sum_{i=1}^{T} (T-i) R_{V-T+i} \right)$$

where the part

$$\sum_{i=1}^{V-T} \left( (V - T - i) + Tw \right) R_i + w \sum_{i=1}^{T} (T-i) R_{V-T+i}$$

shall be minimized if the amount of binary egress memory shall be minimized.

That is to say, in one or more embodiments, method 1500 may include selecting size of the window of the at least one windowed decoder stage to minimize the expression $\sum_{j=1}^{T-1} (T - j) w_{V-T+j}$, where $T$ denotes a number of decoder stages operating as windowed LDPC convolutional decoders, while maintaining a QoS above a predefined threshold. In one embodiment, maintaining the quality of service above the predefined threshold includes keeping a decoded signal error rate at a given SNR below a predefined error rate threshold.

In one or more embodiments, method 1500 may further include receiving a transmission channel output signal, estimating a modulation symbol of an $M$-ary modulation scheme based on the transmission channel output signal $Y_t$, mapping the estimated $M$-ary modulation symbol to a $V$-ary binary address word $(b_1, b_2 ..., b_V)$, wherein $M = 2^V$, and inputting the $i$-th bit $b_i$ of the binary address word to the $i$-th decoder stage 1602-i.

In one or more embodiments, the LDPC block decoding rule and/or the LDPC convolutional decoding rules are based on an iterative row-layered decoding rule, respectively. The at least one LDPC convolutional code may use a syndrome former memory $\mu \geq 1$.

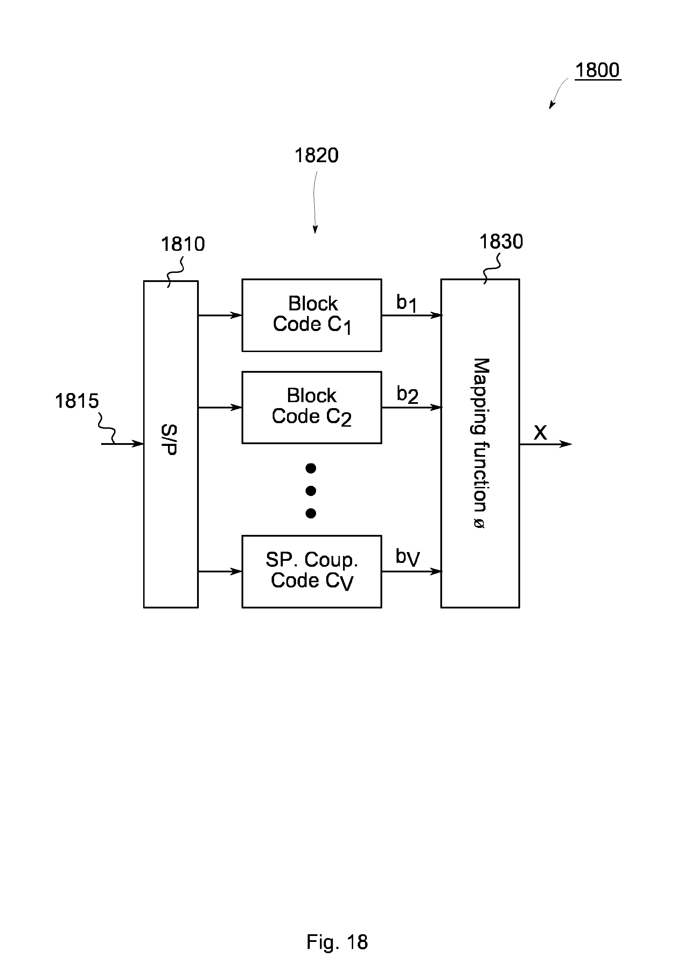

According to yet a further aspect, embodiments also provide a corresponding multilevel coding concept. The multilevel coding concept includes a multilevel coding method as well as a multilevel coding apparatus for performing said method. A block diagram of the multilevel coding apparatus 1800 is schematically illustrated in Fig. 18.

The encoding apparatus 1800 comprises a partitioning processor 1810 configured to partition a block of source data bits 1815 into V source data sub-blocks. The apparatus 1800 also includes an encoder 1820 configured to encode at least a first of the $V$ source data sub-blocks with at least a first LDPC block code, e.g., $C_1$, to obtain at least a first of $V$ encoded bit streams, and to encode at least a second of the $V$ source data sub-blocks with at least a second LDPC convolutional code, e.g., $C_V$, to obtain at least a second of the $V$ encoded bit streams. Bits of the $V$ encoded bit streams form a $V$-ary binary address word $(b_1, b_2 ..., b_V)$. The coding apparatus 1800 also includes a mapper 1830 configured to map, based on a predetermined mapping function $\phi$, the binary address word $(b_1, b_2 ... , b_V)$ to a modulation symbol $X$ of an $M$-ary modulation scheme, with $M = 2^V$. The modulation symbol $X$ may be transmitted over a transmission channel, which may be an optical channel.

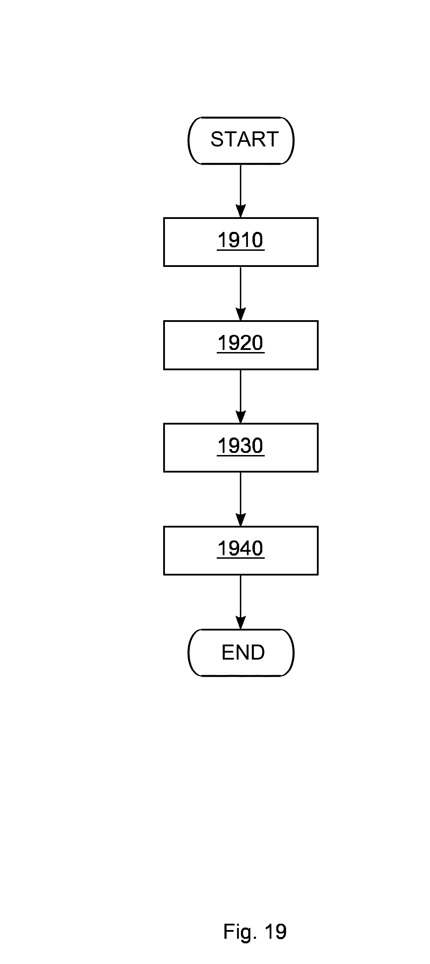

The apparatus is configured to perform a corresponding multilevel coding method 1900. A flow-chart of method 1900 is schematically illustrated in Fig. 19.

Method 1900 comprises an act 1910 of partitioning or converting a block of source data bits into $V$ source data sub-blocks, an act 1920 of encoding at least a first of the $V$ source data sub-blocks with at least a first LDPC block code, e.g., $C_1$, to obtain at least a first of $V$ encoded bit streams, and an act 1930 of encoding at least a second of the $V$ source data sub-blocks with at least a second LDPC convolutional code, e.g., $C_V$, to obtain at least a second of the $V$ encoded bit streams. Bits of the $V$ encoded bit streams form a $V$-ary binary address word $(b_1, b_2 ..., b_V)$. Method 1900 further includes mapping 1940 the binary address word $(b_1, b_2 ... , b_V)$ to a modulation symbol $X$ of an $M$-ary modulation scheme by using a predetermined mapping function $\phi$, which has been described above.

The mutual information $I(X; Y)$ between the modulation symbol $X$ and a transmission channel output $Y$ equals the mutual information $I(b_1, b_2 ..., b_V; Y)$ between the binary address word $(b_1, b_2 ... , b_V)$ and the transmission channel output $Y$. In some embodiments, the predetermined mapping function $\phi$ or the mapper 1830 may be configured to minimize the expression

$$\sum_{i=1}^{V-T} \left((V-T-i)+Tw\right)I(b_i;Y\,|\,b_1,...,b_{i-1}) + w\sum_{i=1}^{T}(T-i)I(b_{V-T+i};Y\,|\,b_1,...,b_{V-T+i-1})$$

for a plurality of possible mapping functions, with $I(b_i; Y|b_1, ..., b_{i-1})$ denoting the mutual information of an equivalent or virtual transmission channel $i$ for transmitting bit $b_i$ of the binary address word, provided that the bits $b_1, ... , b_{i-1}$ are known.

Prior to mapping the binary address word to the modulation symbol, the expression

$$\sum_{i=1}^{V-T} \left((V-T-i)+Tw\right)I(b_i;Y\,|\,b_1,...,b_{i-1}) + w\sum_{i=1}^{T}(T-i)I(b_{V-T+i};Y\,|\,b_1,...,b_{V-T+i-1})$$

may be determined for the plurality of possible mapping functions. Then minimum among the respective determined expressions may be determined. The mapping function corresponding to the minimum expression may be selected as the predetermined mapping function. In one embodiment, the expression

$$\sum_{i=1}^{V-T} \left((V-T-i)+Tw\right)I(b_i;Y\,|\,b_1,...,b_{i-1}) + w\sum_{i=1}^{T}(T-i)I(b_{V-T+i};Y\,|\,b_1,...,b_{V-T+i-1})$$

may be determined for all $M!$ possible mapping functions, respectively. Thereby, determining the minimum may comprise modeling the transmission channel as an AWGN channel, for example.

To summarize, the ideas of embodiments present herein are threefold: Firstly, the decoder memory utilization may be decreased by the use of a special bit mapping that reduces the memory consumption of the egress memories. Further, ingress memories, which need to store complex values, may be reduced. This may be achieved by an optimization of the codes such that the decoding delays are minimized and/or by using hybrid schemes, where spatially coupled or convolutional LDPC codes are combined with conventional block codes yielding an overall minimized memory usage.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks shall be understood as functional blocks comprising circuitry that is adapted for performing a certain function, respectively. Hence, a "module or entity for s.th." may as well be understood as a "module or entity being adapted or suited for s.th.". A module or entity being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. Multilevel coding method (1000), comprising:

   partitioning (1010) a block of source data bits into $V$ source data sub-blocks;
   encoding (1020) the $V$ source data sub-blocks with a respective component code to obtain $V$ encoded bit streams, wherein bits of the $V$ encoded bit streams form a $V$-ary binary address word ($b_1, b_2 \ldots , b_V$);
   mapping (1030), using a predetermined mapping function, the binary address word to a modulation symbol $X$

of an *M*-ary modulation scheme, wherein the mutual information *I*(*X*; *Y*) between the modulation symbol *X* and a transmission channel output *Y* equals the mutual information *I*(*b₁*, *b₂* ..., *b_V*; *Y*) between the binary address word (*b₁*, *b₂* ... , *b_V*) and the transmission channel output *Y*; and wherein the predetermined mapping function minimizes the expression

$$\sum_{i=1}^{V}(V - i)I(\boldsymbol{b}_i \, ; Y | \boldsymbol{b}_1, \ldots, \boldsymbol{b}_{i-1})$$ for a plurality of possible mapping functions,

with *I*(*b_i*; *Y*|*b₁*, ..., *b_{i-1}*) denoting the mutual information of an equivalent transmission channel *i* for transmitting bit *b_i* of the binary address word, provided that the bits *b₁*, ..., *b_{i-1}* are known.

2. The method (1000) of claim 1, further comprising
transmitting (1040) the modulation symbol *X* over a transmission channel (706).

3. The method (1000) of claim 1, wherein encoding (1020) the source data sub-blocks comprises encoding each source data sub-block with a respective Low Density Parity Check (LDPC) convolutional code having a syndrome former memory $\mu \geq 1$.

4. The method (1000) of claim 1, comprising:

encoding at least a first of the *V* source data sub-blocks with at least a first LDPC block code to obtain at least a first of the *V* encoded bit streams;
encoding at least a second of the *V* source data sub-blocks with at least a second LDPC convolutional code to obtain at least a second of the *V* encoded bit streams.

5. The method (1000) of claim 1, comprising, prior to mapping the binary address word (*b₁*, *b₂* ... , *b_V*) to the modulation symbol *X*:

determining the expression $\sum_{i=1}^{V}(V - i)I(\boldsymbol{b}_i \, ; Y | \boldsymbol{b}_1, \ldots, \boldsymbol{b}_{i-1})$ for the plurality of possible mapping functions, respectively,
determining the minimum among the respective determined expressions; and
choosing the mapping function corresponding to the minimum expression as the predetermined mapping function.

6. The method (1000) of claim 5, wherein the expression

$$\sum_{i=1}^{V}(V - i)I(\boldsymbol{b}_i \, ; Y | \boldsymbol{b}_1, \ldots, \boldsymbol{b}_{i-1})$$ is determined for all *M*! possible mapping functions, respectively.

7. The method (1000) of claim 5, wherein determining the minimum comprises modeling the transmission channel as an Additive White Gaussian Noise, AWGN, channel.

8. Multistage decoding method (1200), comprising:

using (1210) a first windowed decoder stage (1302-1) operating on a window of $w_1$ copies of a submatrix defining a first parity-check matrix of a first LDPC convolutional code to decode, in accordance with a first LDPC decoding rule based on the first parity-check matrix, one or more first data bits of a first bit stream encoded with the first LDPC convolutional code, the first bit stream being one of $V \geq 2$ encoded bit streams;
using (1220) the decoded one or more first data bits as input for at least a second windowed decoder stage (1302-2) operating on a window of $w_2$ copies of a submatrix defining a second parity-check matrix of a second LDPC convolutional code to decode, in accordance with a second LDPC decoding rule based on the second parity-check matrix, one or more second data bits of a second bit stream encoded with the second LDPC convolutional code, the second bit stream being one of the *V* encoded bit streams;
wherein selecting sizes $w_1$, ..., $w_V$ of the windows of the V windowed decoders comprises minimizing the

expression $\sum_{j=1}^{V}(V - j)w_j$, while maintaining a quality of service above a predefined threshold.

9. The method of claim 8, wherein maintaining the quality of service above the predefined threshold comprises keeping a decoded signal error rate at a given Signal-to-Noise Ratio below a predefined error rate threshold.

10. The method of claim 8, wherein minimizing the expression $\sum_{j=1}^{V}(V - j)w_j$ comprises minimizing the expression

$\sum_{j=1}^{V-1}\left(O\sum_{i=1}^{j}w_i + R_i\sum_{i=j+1}^{V}w_i\right)$, wherein $O$ de-notes a factor related to a bitwidth of information to be stored in a decoder memory and wherein $R_i = I(b_i; Y|b_1,...,b_{i-1})$ denotes a coding rate of the $i$-th component LDPC convolutional code.

11. The method of claim 8, further comprising:

receiving a transmission channel output signal;
estimating a modulation symbol of an $M$-ary modulation scheme based on the transmission channel output signal; and
mapping the estimated $M$-ary modulation symbol to a $V$-ary binary address word $(b_1, b_2 ..., b_V)$, wherein $M = 2^V$; and
inputting the $i$-th bit $b_i$ of the binary address word to the $i$-th windowed decoder stage.

12. The method of claim 8, further comprising:

receiving a transmission channel output signal;
estimating a modulation symbol of an $M$-ary modulation scheme based on the transmission channel output signal; and
mapping the estimated $M$-ary modulation symbol to a $V$-ary binary address word $(b_1, b_2 ..., b_V)$, wherein $M = 2^V$; and
inputting the $i$-th bit $b_i$ of the binary address word to the $i$-th windowed decoder stage.

13. Multistage decoding method (1500), comprising:

using (1510) at least a first decoder stage to decode (1602-1), in accordance with at least a first LDPC decoding rule corresponding to a first LDPC block code ($C_1$), one or more first data bits of a first bit stream encoded with the first LDPC block code ($C_1$), the first bit stream being one of $V \geq 2$ encoded bit streams;
using (1520) the decoded one or more first data bits as input for at least a second decoder stage (1602-2; 1602-V) operating on a window of $w_2$ copies of a submatrix defining a second parity-check matrix of at least a second LDPC convolutional code ($C_2$; $C_V$) to decode, in accordance with a second LDPC decoding rule based on the second parity-check matrix, one or more second data bits of a second bit stream encoded with the second LDPC convolutional code ($C_2$; $C_V$), the second bit stream being one of the $V$ encoded bit streams.

14. The method (1500) of claim 13, wherein selecting size of the window of the at least second decoder stage comprises minimizing the expression

$$N\left(-\frac{T^2}{2} + \frac{T}{2} + \frac{V^2}{2} - \frac{V}{2} + \sum_{i=1}^{T-1}(T-i)w_{V-T+1}\right),$$ $T$ denoting a number of decoder stages operating as windowed decoders, while maintaining a quality of service above a predefined threshold.

15. The method (1500) of claim 13, further comprising:

receiving a transmission channel output signal;
estimating a modulation symbol of an $M$-ary modulation scheme based on the transmission channel output signal; and
mapping the estimated $M$-ary modulation symbol to a $V$-ary binary address word $(b_1, b_2 ..., b_V)$, wherein $M = 2^V$; and
inputting the $i$-th bit $b_i$ of the binary address word to the $i$-th decoder stage.

16. Multilevel coding method (1900), comprising:

partitioning (1910) a block of source data bits into $V$ source data sub-blocks;
encoding (1920) at least a first of the $V$ source data sub-blocks with at least a first LDPC block code ($C_1$) to obtain at least a first of $V$ encoded bit streams,
encoding (1930) at least a second of the $V$ source data sub-blocks with at least a second LDPC convolutional code ($C_2$; $C_V$) to obtain at least a second of the $V$ encoded bit streams,

wherein bits of the *V* encoded bit streams form a *V*-ary binary address word ($\boldsymbol{b_1}$, $\boldsymbol{b_2}$ ... , $\boldsymbol{b_V}$); and
mapping (1940), using a predetermined mapping function, the binary address word to a modulation symbol *X*
of an *M*-ary modulation scheme.

**17.** The method (1900) of claim 16, wherein the mutual information *I(X; Y)* between the modulation symbol *X* and a
transmission channel output *Y* equals the mutual information *I($\boldsymbol{b_1}$, $\boldsymbol{b_2}$ ..., $\boldsymbol{b_V}$; Y)* between the binary address word
($\boldsymbol{b_1}$, $\boldsymbol{b_2}$ ... , $\boldsymbol{b_V}$) and the transmission channel output *Y*, and wherein the predetermined mapping function minimizes
the expression

$$\sum_{i=1}^{V-T}\left((V-T-i)+Tw\right)I(b_i;Y\,|\,b_1,...,b_{i-1}) + w\sum_{i=1}^{T}(T-i)I(b_{V-T+i};Y\,|\,b_1,...,b_{V-T+i-1})$$

for a plurality of possible mapping functions,
with *I($\boldsymbol{b_i}$; Y|$\boldsymbol{b_1}$, ..., $\boldsymbol{b_{i-1}}$)* denoting the mutual information of an equivalent transmission channel *i* for transmitting bit
$\boldsymbol{b_i}$ of the binary address word, provided that the bits $\boldsymbol{b_1}$, ..., $\boldsymbol{b_{i-1}}$ are known, *T* denoting a number of bit streams
encoded with a respective LDPC convolutional code, and *w* denoting a windows size of a windowed decoder to
decode the bit streams encoded with a respective LDPC convolutional code.

**18.** The method (1900) of claim 16, comprising, prior to mapping the binary address word to the modulation symbol:

determining the expression

$$\sum_{i=1}^{V-T}\left((V-T-i)+Tw\right)I(b_i;Y\,|\,b_1,...,b_{i-1}) + w\sum_{i=1}^{T}(T-i)I(b_{V-T+i};Y\,|\,b_1,...,b_{V-T+i-1})$$

for the plurality of possible mapping functions, respectively,
wherein *T* denotes a number of bit streams encoded with a respective LDPC convolutional code and *w* denotes
a windows size of a windowed decoder to decode the bit streams encoded with a respective LDPC convolutional
code
determining the minimum among the respective determined expressions; and
choosing the mapping function corresponding to the minimum expression as the predetermined mapping function.

EP 2 991 231 A1

Fig. 1

Fig. 2a

EP 2 991 231 A1

Fig. 2b

Fig. 3

Fig. 4

Fig. 5

$101 = b_1b_2b_3$

100     111

000         110

001    010

011

Fig. 6

701    702    704

S/P

Code $C_1$   $b_1$

Code $C_2$   $b_2$

Code $C_V$   $b_V$

Mapping function $\phi$

X

706

Channel

Y

708-1    708-2

Decoder $D_1$

$\hat{b}_1$

Decoder $D_2$

$\hat{b}_2$

$\hat{b}_V$

Decoder $D_V$

P/S

708-V

Fig. 7

808-1    808-2    808-3    808-V

Time t

| Decoder $D_1$ $Y_t$ | Decoder $D_2$ $Y_{t-1} \mid b_1$ | Decoder $D_3$ $Y_{t-2} \mid b_1b_2$ | ... | Decoder $D_V$ $Y_{t-V+1} \mid b_1...b_{V-1}$ |

Time t+1

| Decoder $D_1$ $Y_{t+1}$ | Decoder $D_2$ $Y_t \mid b_1$ | Decoder $D_3$ $Y_{t-1} \mid b_1b_2$ | ... | Decoder $D_V$ $Y_{t-V+2} \mid b_1...b_{V-1}$ |

Time t+2

| Decoder $D_1$ $Y_{t+2}$ | Decoder $D_2$ $Y_{t+1} \mid b_1$ | Decoder $D_3$ $Y_t \mid b_1b_2$ | ... | Decoder $D_V$ $Y_{t-V+1} \mid b_1...b_{V-1}$ |

Fig. 8

Fig. 9

1000

START

1010

1020

1030

1040

END

Fig. 10

Fig. 11

1200

START

1210

1220

END

Fig. 12

Fig. 13

Fig. 14

1500

```
         │
         ▼
┌─────────────────┐
│      1510       │
└─────────────────┘
         │
         ▼
┌─────────────────┐
│      1520       │
└─────────────────┘
         │
         ▼
```

Fig. 15

Fig. 16

Fig. 17

EP 2 991 231 A1

1800

1820

1810

1815

1830

| S/P | Block<br>Code C₁ | $b_1$ | Mapping function ø | X |
| | Block<br>Code C₂ | $b_2$ | | |
| | • • • | | | |
| | SP. Coup.<br>Code C$_V$ | $b_V$ | | |

Fig. 18

```
        ┌─────────────┐
        │    START    │
        └──────┬──────┘
               │
               ▼
        ┌─────────────┐
        │    1910     │
        └──────┬──────┘
               │
               ▼
        ┌─────────────┐
        │    1920     │
        └──────┬──────┘
               │
               ▼
        ┌─────────────┐
        │    1930     │
        └──────┬──────┘
               │
               ▼
        ┌─────────────┐
        │    1940     │
        └──────┬──────┘
               │
               ▼
        ┌─────────────┐
        │     END     │
        └─────────────┘
```

Fig. 19

Europäisches
Patentamt
European
Patent Office
Office européen
des brevets

# EUROPEAN SEARCH REPORT

Application Number

EP 14 18 3086

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DONG-FENG YUAN ET AL: "Comparison of multilevel coded modulation with different decoding methods over AWGN channels", PROC., IEEE SYMPOSIUM ON PERSONAL, INDOOR AND MOBILE RADIO COMMUNICATIONS, PIMRC 2000, vol. 1, 18 September 2000 (2000-09-18), - 21 September 2000 (2000-09-21), pages 567-571, XP010520700, ISBN: 978-0-7803-6463-9 | 1-3 | INV.<br>H03M13/11<br>H03M13/25<br>H04L1/00 |
| A | * the whole document * | 4-18 | |
| X | YU YI ET AL: "Optimized low-density parity-check (LDPC) codes for bandwidth efficient modulation", PROC., IEEE VEHICULAR TECHNOLOGY CONFERENCE, VTC 2003-FALL, ORLANDO, FL, USA, vol. 4, 6 October 2003 (2003-10-06), - 9 October 2003 (2003-10-09), pages 2367-2370, XP010701416, DOI: 10.1109/VETECF.2003.1285953 ISBN: 978-0-7803-7954-1 | 1-3 | |
| A | * the whole document * | 4-18 | TECHNICAL FIELDS SEARCHED (IPC)<br>H03M<br>H04L |
| X | YI Y LEE M H: "SEMI-ALGEBRAIC LOW-DENSITY PARITY-CHECK (SA-LDPC) CODES FOR BANDWIDTH EFFICIENT MODULATION", PROC., INTERNATIONAL SYMPOSIUM ON TURBO CODES AND RELATED TOPICS, 4 September 2003 (2003-09-04), pages 379-382, XP009043204, | 1-3 | |
| A | * the whole document * | 4-18 | |

-/--

The present search report has been drawn up for all claims

| Place of search | Date of completion of the search | Examiner |
|---|---|---|
| Munich | 5 March 2015 | Offer, Elke |

EPO FORM 1503 03.82 (P04C01)

Europäisches
Patentamt

European
Patent Office

Office européen
des brevets

**EUROPEAN SEARCH REPORT**

Application Number

EP 14 18 3086

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | T. ARAFA ET AL: "Improving the performance of BICM-ID and MLC systems with different FEC codes", ADVANCES IN RADIO SCIENCE, vol. 11, 1 January 2013 (2013-01-01), pages 87-93, XP055151057, DOI: 10.5194/ars-11-87-2013 * the whole document * | 1-18 | |
| A | NARAYANAN K R ET AL: "BANDWIDTH EFFICIENT LOW DENSITY PARITY CHECK CODING USING MULTI LEVEL CODING AND ITERATIVE MULTI STAGE DECODING", PROC., INTERNATIONAL SYMPOSIUM ON TURBO CODES AND RELATED TOPICS, 4 September 2000 (2000-09-04), pages 165-168, XP009021988, * the whole document * | 1-18 | |
| Y | PITTERMANN J ET AL: "On coded modulation using LDPC convolutional codes", AEU INTERNATIONAL JOURNAL OF ELECTRONICS AND COMMUNICATIONS, ELSEVIER, JENA, DE, vol. 59, no. 4, 15 June 2005 (2005-06-15), pages 254-257, XP027820792, ISSN: 1434-8411 [retrieved on 2005-06-15] | 8,9,11, 12 | TECHNICAL FIELDS SEARCHED (IPC) |
| A | * the whole document * | 1-7, 13-18 | |

-/--

The present search report has been drawn up for all claims

| Place of search | Date of completion of the search | Examiner |
|---|---|---|
| Munich | 5 March 2015 | Offer, Elke |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

Europäisches
Patentamt
European
Patent Office
Office européen
des brevets

**EUROPEAN SEARCH REPORT**

Application Number

EP 14 18 3086

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | Pusane A. E. ET AL: "Multilevel Coding/Modulation Using LDPC Convolutional Codes", Proc., International Symposium on Information Theory and its Applications, ISITA2004, Parma, Italy, 10 October 2004 (2004-10-10), XP055172836, Retrieved from the Internet: URL:http://www3.nd.edu/~eecoding/papers/PLFZCisita04.pdf [retrieved on 2015-03-02] | 8,9,11,12 | |
| A | * page 1 - page 2 * | 1-7,10,13-18 | |
| | ----- | | |
| Y | LENTMAIER M. ET AL: "Efficient message passing scheduling for terminated LDPC convolutional codes", PROC., IEEE INTERNATIONAL SYMPOSIUM ON INFORMATION THEORY, ISIT 2011, ST. PETERSBURG, RUSSIA, 31 July 2011 (2011-07-31), - 5 August 2011 (2011-08-05), pages 1826-1830, XP031971529, DOI: 10.1109/ISIT.2011.6033865 ISBN: 978-1-4577-0596-0 * abstract * * page 1826 * * page 1829 - page 1830 * | 8,9,11,12 | |

TECHNICAL FIELDS SEARCHED (IPC)

-/--

The present search report has been drawn up for all claims

| Place of search | Date of completion of the search | Examiner |
|---|---|---|
| Munich | 5 March 2015 | Offer, Elke |

EPO FORM 1503 03.82 (P04C01)

**Europäisches Patentamt**
**European Patent Office**
**Office européen des brevets**

# EUROPEAN SEARCH REPORT

Application Number

EP 14 18 3086

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SCHMALEN L. ET AL: "Forward error correction in optical core and optical access networks", BELL LABS TECHNICAL JOURNAL, WILEY, CA, US, vol. 18, no. 3, 1 December 2013 (2013-12-01), pages 39-66, XP011569567, ISSN: 1089-7089, DOI: 10.1002/BLTJ.21627 [retrieved on 2014-03-15] * page 49, right-hand column - page 51, left-hand column * * page 55, right-hand column - page 57, right-hand column * * page 58, right-hand column, paragraph 2 * | 1-18 | |
| A | LEVEN ANDREAS ET AL: "Status and Recent Advances on Forward Error Correction Technologies for Lightwave Systems", JOURNAL OF LIGHTWAVE TECHNOLOGY, IEEE SERVICE CENTER, NEW YORK, NY, US, vol. 32, no. 16, 15 August 2014 (2014-08-15), pages 2735-2750, XP011554214, ISSN: 0733-8724, DOI: 10.1109/JLT.2014.2319896 [retrieved on 2014-07-22] * the whole document * | 1-18 | **TECHNICAL FIELDS SEARCHED (IPC)** |

The present search report has been drawn up for all claims

| Place of search | Date of completion of the search | Examiner |
|---|---|---|
| Munich | 5 March 2015 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**Application Number**

EP 14 18 3086

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 14 18 3086

The Search Division considers that the present European patent application does not comply with the requirements of unity of invention and relates to several inventions or groups of inventions, namely:

1. claims: 1-7

   Independent method claim 1 specifies a multilevel coding method comprising
   - encoding using V component codes to form a binary address word and
   - mapping the binary address word to a modulation symbol of an M-ary modulation scheme
   - wherein the mapping function minimizes a particular summation based on the mutual information of the equivalent transmission channels .
   ---

2. claims: 16-18

   Independent claim 16 specifies a multilevel coding method comprising
   - encoding using V component codes to form a binary address word and
   - mapping the binary address word to a modulation symbol of an M-ary modulation scheme
   - wherein a first of said component codes is an LDPC block code and a second of said component codes is an LDPC convolutional code.
   ---

3. claims: 8-12

   Independent claim 8 specifies a multistage decoding method comprising
   - using a first windowed decoder stage operating on a window of size w1 to decode a first bit stream encoded with a first LDPC convolutional code and
   - using a second windowed decoder stage operating on a window of size w2 to decode a second bit stream encoded with a second LDPC convolutional code
   - wherein the window sizesw1andw2 are selected to minimize a particular expression.
   ---

4. claims: 13-15

   Independent claim 13 specifies a multistage decoding method comprising
   - using a first decoder stage to decode a first bit stream encoded with a first LDPC block code and
   - using a second decoder stage operating on a window of size w2 to decode a second bit stream encoded with a second LDPC convolutional code.
   ---

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **F. BUCHALI et al.** 1-Tbit/s dual-carrier DP 64QAM transmission at 64Gbaud with 40% overhead soft-FEC over 320km SSMF. *in OFC/NFOEC,* 2013
- **R. BATTITI ; G. TECCHIOLLI.** The reactive tabu search. *ORSA Journal on Computing,* 1994, vol. 6, 126-140
- **F. SCHRECKENBACH.** Iterative Decoding of Bit-Interleaved Coded Modulation. *PhD thesis,* 2007
- **K. ZEGER ; A. GERSHO.** Pseudo-Gray coding. *IEEE Transactions on Communications,* December 1990, vol. 38, 2147-2158
- **V. AREF ; L. SCHMALEN ; S. TEN BRINK.** On the Convergence Speed of Spatially Coupled LDPC Ensembles. *Allerton Conference,* 2013